Europäisches Patentamt

European Patent Office

Office européen des brevets

(19)

(11) EP 0 518 633 B1

(12) EUROPEAN PATENT SPECIFICATION

(45) Date of publication and mention
of the grant of the patent:
**12.11.1997 Bulletin 1997/46**

(51) Int Cl.6: **H01J 37/30**, H01J 37/305,
H01J 37/244

(21) Application number: **92305311.0**

(22) Date of filing: **10.06.1992**

(54) **Pattern inspection apparatus and electron beam apparatus**

Apparat zur Musterüberprüfung und Elektronenstrahlgerät

Appareil pour l'inspection de motif et appareil à faisceau électronique

(84) Designated Contracting States:
**DE FR GB**

(30) Priority: 10.06.1991 JP 137692/91
20.09.1991 JP 241549/91
14.11.1991 JP 298838/91
29.11.1991 JP 316676/91

(43) Date of publication of application:
**16.12.1992 Bulletin 1992/51**

(73) Proprietor: **FUJITSU LIMITED
Kawasaki-shi, Kanagawa 211 (JP)**

(72) Inventors:
• **Honjo, Ichiro, c/o Fujitsu Limited
Kawasaki-shi, Kanagawa, 211 (JP)**
• **Sugishima, Kenji, c/o Fujitsu Limited
Kawasaki-shi, Kanagawa, 211 (JP)**
• **Yamabe, Masaki, c/o Fujitsu Limited
Kawasaki-shi, Kanagawa, 211 (JP)**

(74) Representative: **Gibbs, Christopher Stephen et al
Haseltine Lake & Co.,
Imperial House,
15-19 Kingsway
London WC2B 6UD (GB)**

(56) References cited:
EP-A- 0 289 278          EP-A- 0 339 951
EP-A- 0 379 865          FR-A- 2 220 871
US-A- 4 983 830

• JOURNAL OF APPLIED PHYSICS. vol. 47, no. 12,
December 1976, NEW YORK US pages 5248 -
5263; C.A. SPINDT ET AL.: 'PHYSICAL
PROPERTIES OF THIN-FILM FIELD EMISSION
CATHODES WITH MOLYBDENUM CONES'
• PATENT ABSTRACTS OF JAPAN vol. 8, no. 88
(E-240)(1525) 21 April 1984 & JP-A-59 006 537
• PATENT ABSTRACTS OF JAPAN vol. 8, no. 99
(E-243)10 May 1984 & JP-A-59 016 255
• JOURNAL OF VACUUM SCIENCE AND
TECHNOLOGY: PART B. vol. 4, no. 3, May 1986,
NEW YORK US pages 686 - 691; K. SAITOH ET
AL.: 'ELECTRON BEAM PATTERN INSPECTION
SYSTEM USING IMAGE PROCESSING'
• PATENT ABSTRACTS OF JAPAN vol. 6, no. 152
(P-134)12 August 1982 & JP-A-57 072 072

## Description

The present invention relates to a pattern inspection apparatus. More specifically, the invention relates to a pattern inspection apparatus for performing an inspection of a mask pattern, such as a mask, reticle and so forth to be used in exposure technology for transferring a fine circuit pattern on a semiconductor substrate or a fine circuit pattern formed on a wafer. In particular, the invention relates to a pattern inspection apparatus for inspecting a pattern configuration or a defect or an error in the pattern configuration of inspection samples, such as a mask to be used for X-ray exposure technology for transferring a fine circuit pattern and so forth on the semiconductor substrate employing X-rays including a synchrotron radiation beam (SOR), a wafer, in which the fine circuit pattern is formed on the semiconductor substrate or a mask, reticle or so forth to be used in light exposure technology for transferring a fine circuit pattern to the semiconductor substrate employing ultra-violet light as a light source.

Conventionally, in order to transfer a fine circuit pattern onto a semiconductor substrate, ultra-violet light is used as a light source. Normally, a mask containing patterns for several chips is employed to perform a transfer of a compressed pattern by periodically shifting the transfer position on the wafer in a step-and-repeat manner, on a large diameter wafer. At this time, for defect inspection of the wafer pattern for checking foreign matter or a defect on the mask pattern or for defect inspection of the foreign matter on the wafer or the wafer pattern, an optical method employing an optical micrograph is frequently used. However, along with increasing density of the fine circuit patterns, it has become necessary to provide a light source with a shorter wave length for use in the wafer pattern inspection. In a conventional light source employing a conventional optical system, the resolution cannot be improved because of a specific diffraction limit making it difficult to detect very small defects.

As a solution, inspection technology employing an electron beam has been developed.

In view of the increasing density of circuit patterns, X-ray exposure technology employing an X-ray containing synchrotron radiation beam (SOR) is regarded as one of the important next-generation transfer technologies. Simultaneously, it is becoming necessary to shorten the wavelengths used for inspection of the X-ray mask.

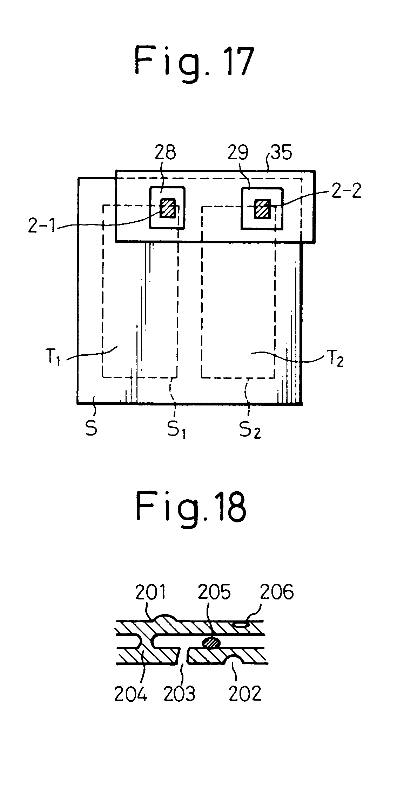

In the prior art, when inspecting a mask, reticle, wafer on which a specific pattern is formed, and so forth, the subject of inspection is foreign matter (particles) adhering on the surface of the mask, reticle, wafer etc., or a defect of the pattern as shown in Fig. 18, such as a protrusion 201, a intrusion 202, a break 203, a bridge contact 204, a pin spot 205, pin hole 206 and so forth. The generally required sensitivity (resolution) is, for example, in the case of foreign matter:-

for a bare wafer: (pattern dimension) x 1/7 to 1/5
for a patterned wafer: (pattern dimension) x 1
for a reticle or mask: transfer limit.

On the other hand, in the case of a pattern defect, the required sensitivity level is generally (line width) x 1/2.

With an increase in the pattern density and an increase in package density, higher resolution becomes necessary. However, in the case of an inspection process employing a light beam, there is a limit on the resolution obtainable. Even when the wavelength is shortened, the highest possible resolution for visual light is 0.25 $\mu$m. Therefore, the size of devices capable of being inspected is limited to a 4M to 16M DRAM. On the other hand, even when an ultra-violet light beam is employed, the maximum possible resolution is 0.15 $\mu$m. In this case, the size of devices to be inspected can be up to 64M DRAM. Therefore, it is difficult to effect an inspection suitable for 256M DRAM or next generation devices achieving a further reduced size and greater packing density, such as a 1G DRAM.

Therefore, a method employing an electron beam in place of the light beam has been considered.

By employing an electron beam, fewer problems result by increasing the pattern density and this can permit the fabrication and inspection of higher density patterns than with a light beam.

However, in a prior art electron beam inspection process, there is a problem in that the information detected by a detecting means is processed serially (independently in a time sequence) and therefore, a relatively long data processing period is required.

In addition, as set forth above, along with an increase of circuit pattern density and an increase of package density, the amount of data to be processed in pattern inspection of the device is naturally increased. Therefore, a greater arithmetic processing capacity becomes necessary.

For example, a processing capacity for $(1 \text{ cm}/0.1 \ \mu\text{m})^2 = 100 \text{ M pixel/cm}^2$, i.e. 31G pixel/wafer for an 8" wafer, is becoming necessary.

Meanwhile, along with an increase of the density of the circuit pattern, the size of the pattern unit (i.e. area of the sample) for processing to check whether a defect is present is becoming smaller. In addition, the capacity of each individual chip is increasing. Therefore, the amount of information to be processed for inspection is rapidly increasing. In a conventional electron beam system, a single electron beam is scanned over the mask in order to allow detection of the generated secondary electrons, backscattered electrons or transmitted electrons. Therefore, signals from successive irradiating regions of the electron beam with high convergence for detecting very small defects, are generated continuously in a time sequence. This leads to a long time period for transmission of the image information to a signal processing system. Therefore, even when the capacity of the signal processing system is increased, a long time period is still required for inspection.

In more detail, the electron beam is scanned over a sample, such as a mask, wafer or so forth in order to cause electrons emitted from the irradiated portion to arrive at a detecting portion. The electron current detected by the detecting portion contains configuration information relating to the pattern. From the signal formed by the electrons, the pattern information can be obtained in a time sequence.

The electrons detected by the detecting portion are secondary electrons whose direction of incidence upon the detecting portion varies depending upon the configuration of the inspection sample, backscattered electrons whose amount varies depending upon the material and configuration of the inspecting sample, or transmitted electrons whose amount varies depending upon the pattern when the inspecting sample is a thin film mask, an X ray mask or so forth. By analysing the detected signals, the plane configuration and three dimensional configuration, such as projections and recesses and so forth, can be recognized.

However, as set forth above, the method employing the electron beam has a problem in that the inspection speed is slow, requiring a long processing period.

EP-A-0 289 278 discloses an electron beam apparatus according to the preamble of accompanying claim 1. This is a pattern drawing apparatus for drawing patterns on a wafer, the detectors being used to detect the presence of wafer alignment marks so as to detect any change in the shape of the wafer.

According to the present invention, there is provided an electron beam apparatus comprising:

a plurality of electron beam emitters arranged on a common substrate or on a plurality of individual substrates arranged on the same plane, each arranged to emit an electron beam onto a respective region of a sample and provided with at least a convergence electrode or a converging coil providing a convergence ratio for said electron beam corresponding to an electrode voltage or an energization current;
a plurality of detectors for detecting electrons emitted from said sample; and
signal processing means for processing information output from said detectors;

characterised in that:

said apparatus is a pattern inspection apparatus for inspecting the condition of a pattern formed on said sample; said plurality of detectors correspond one to one with said electron beam emitters and are arranged to detect electrons emitted from said respective regions of said sample; and
said signal processing means is arranged to perform image processing simultaneously or in parallel of the information output from said plurality of detectors.

An embodiment of the invention is thus operable to scan multiple electron beams over the sample, and to use emitted electrons from the sample (for example secondary or backscattered electrons) to detect a defect in a circuit pattern on the sample with a high sensitivity and a high process speed. The present invention is thus suitable for inspecting patterns of masks, wafers and so on used for chips having high density circuit patterns and high package densities.

With this construction, the present invention can detect a fine pattern on the sample with high accuracy. Also, according to the present invention, detection signals of electrons transmitted through the sample or emitted from the surface of the sample, which contain information on the irradiated region of the pattern, are processed simultaneously or in parallel in order to shorten the processing time.

Reference is made, by way of example, to the accompanying drawings in which:

Figs. 1(a) and 1(b) are schematic block diagrams showing a pattern inspection apparatus useful for understanding the present invention;
Fig. 2 is a fragmentary section of a pattern inspection apparatus useful for understanding the invention;
Figs. 3(a) to 3(c) illustrate the principle of a pattern inspection method employing the apparatus illustrated in Fig. 2;
Fig. 4 also illustrates the principle of pattern inspection employing the apparatus in Fig. 2;
Fig. 5 shows a detection means 4 used in a pattern inspection apparatus useful for understanding the invention;
Fig. 6 shows another detection means 4 useful for understanding the invention;
Fig. 7 shows an example of a movable support means 3 useful for understanding the invention;
Fig. 8 shows an example of an electron beam generating means 2 used in an embodiment of the invention;
Fig. 9 shows an irradiating condition of the electron beam when the electron beam generating means 2 of Fig. 8 is employed;

Fig. 10 shows another example of the electron beam generating means 2 used in an embodiment of the invention, in which Fig. 10(a) shows the side elevation of the overall construction, and Fig. 10(b) is a partial enlarged view of Fig. 10(a);

Fig. 11 illustrates an example of an inspection employing a plurality of electron beams by the electron beam generating means 2 of the invention;

Fig. 12 shows an example of the construction of the electron beam generating means 2 and detecting means 4 in the construction for detecting backscattered electrons or secondary electrons;

Fig. 13 shows an example of a construction for oscillating or scanning the electron beam generating means 2 in a pattern inspection apparatus embodying the invention;

Fig. 14 shows a scanning condition of an electron beam in Fig. 13;

Fig. 15 shows an example of a drive means for the electron beam generating means 2 for performing simultaneous inspection of adjacent samples in an embodiment of the invention;

Fig. 16 shows an example of an inspection judgement circuit when the drive means for the electron beam generating means in Fig. 15 is employed;

Fig. 17 is a plan view of a pattern inspection performed using the drive means of Fig. 15;

Fig. 18 illustrates examples of defective portions to be detected in the pattern inspection;

Fig. 19 is a block diagram showing a principle of another embodiment of the invention;

Fig. 20 is a block diagram showing the Fig. 19 embodiment in more detail;

Fig. 21(a) to 21(e) show waveforms in various portions of the pattern inspection apparatus of Fig. 20;

Fig. 22 is a section showing a construction of an electron beam irradiating section in the embodiment of Fig. 20;

Fig. 23 is a similar view to Fig. 22 but showing an alternative embodiment of the pattern inspection apparatus;

Fig. 24 is a similar view to Fig. 22 but showing a further embodiment of the pattern inspection apparatus;

Fig. 25 shows a major part of a conventional pattern inspection apparatus;

Fig. 26 illustrates fluctuation of a spot diameter in the prior art;

Fig. 27 illustrates fluctuation of a deflection angle in the prior art;

Fig. 28 shows a principle of another embodiment of the pattern inspection apparatus according to the invention;

Fig. 29 shows the apparatus of Fig. 28 in more detail;

Fig. 30(a) and 30(b) show details of the major part of a circuit $C_i$ with a plan view including the circuit $C_i$;

Fig. 31 shows a connection when an electrode voltage $Vdzi$ of a converging electrode $Edzi$ is adjusted;

Fig. 32 is an illustration of a layout of the basic pattern in one embodiment;

Fig. 33 is a conceptual illustration of a manner for measuring a spot diameter of a spot in a knife edge method according to one embodiment;

Fig. 34 is a conceptual illustration of a manner for measuring a spot diameter by a light metal and a heavy metal according to one embodiment;

Fig. 35 shows another embodiment of the pattern inspection apparatus according to the invention;

Fig. 36 shows a further embodiment of the pattern inspection apparatus according to the invention;

Fig. 37 shows an arrangement of detectors in an embodiment of the invention;

Fig. 38 shows another arrangement of detectors in an embodiment of the invention;

Fig. 39 shows another embodiment of the pattern inspection apparatus according to the invention;

Fig. 40 shows the construction of a signal processing section in an embodiment of the invention;

Fig. 41 shows detection signals representing the presence and absence of a pattern;

Fig. 42(a) to 42(c) illustrate a further embodiment of the pattern inspection apparatus in which (a) shows a fragmentary illustration showing a concept of the embodiment, (b) is a plan view of a mask formed with openings and (c) shows a graph for identifying a position of the mask with the openings;

Fig. 43(a) to 43(d) show wave forms used in a modulation method in another embodiment of the present invention;

Fig. 44 shows a switching means used in an embodiment of the invention;

Fig. 45 shows another type of the switching means used in an embodiment of the invention; and

Fig. 46 shows a real time controlling circuit used in an embodiment of the invention.

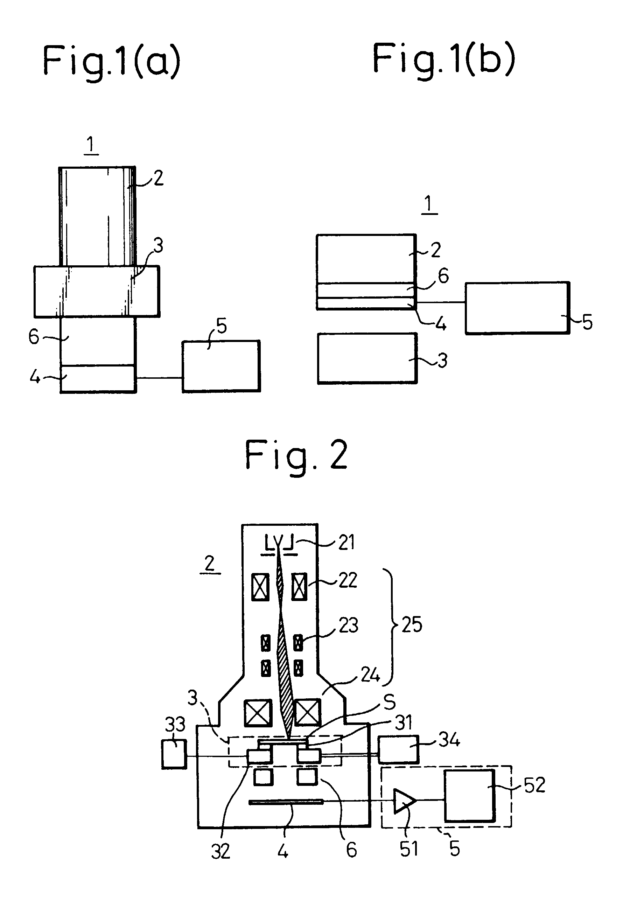

Fig. 1(a) illustrates a pattern inspection apparatus which is not in accordance with the present invention, but is useful for understanding the same. Fig. 1(b) illustrates another such pattern inspection apparatus.

In Figs. 1(a) and 1(b), a pattern inspection apparatus 1 comprises an electron beam generating means 2 having an electron gun for generating an electron beam that is accelerated and converged into a predetermined diameter for irradiating a sample (inspecting or inspection sample), a movable support means 3 for supporting the sample, a detecting means 4, in which are arranged in alignment a plurality of detectors for detecting electrons for obtaining information associated with the construction or condition of the sample, and a detection signal processing means 5 for processing information output from respective detectors of the detecting means 4 simultaneously or in parallel formation.

Fig. 1(a) is basically designed for inspection of circuit patterns by transmitting electrons through a sample such as a mask. On the other hand, the apparatus of Fig. 1(b) is basically adapted to use secondary electrons or backscattered electrons emitted from a sample such as a wafer under irradiation by an electron beam.

An electron beam generating means 2 employed in these apparatuses will now be explained. As set forth above, the conventional method employing a light beam has a limit of resolution due to diffraction effects and therefore, is not suitable for pattern inspection of a sample with high circuit pattern density and high package density. In contrast to this, in the apparatus of Fig. 1(a) or 1(b), an electron beam as a charged particle beam is basically employed. In addition, in the apparatus of Fig. 1(a) or 1(b), the electron beam generating means 2 is designed to generate a highly converged electron beam.

One example of the electron beam generating means 2 comprises an electron gun 21, and an electron optical system 25 including an electromagnetic lens 22, a deflector 23 and an electromagnetic lens 24.

In the drawings, a movable support means 3 comprises a sample stage 31 for supporting the sample S thereon, a XY stage drive mechanism 32 for shifting the sample stage 31 horizontally in one or two directions, and a laser interferometer 33, for example, for detecting a position of the sample stage 31 and generating control signals.

On the other hand, in Fig. 2, the detecting means 4 composed of a plurality of detectors is provided beneath the movable support means 3. The detecting means 4 is designed to receive a plurality of electron beams and to process them simultaneously or in parallel formation. The output of the detecting means 4 includes a detection signal processing means 5 that comprises an amplifier 51 and a signal processing circuit 52.

In a conventional pattern drawing method for fabricating the circuit pattern T on the wafer or the like, a single electron beam is employed so that the electron beam, which is finely focused by means of an appropriate electromagnetic optical system, is irradiated on the wafer and scanned along the intended pattern T so as to form an image of the pattern T.

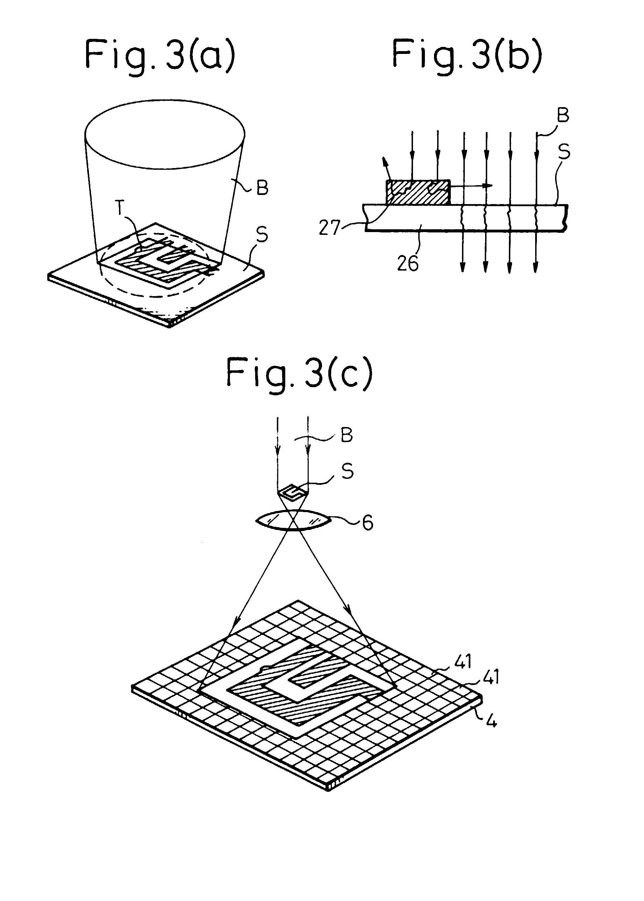

In contrast to this, the Fig. 2 apparatus employs an electron beam for performing an inspection for checking whether the predetermined circuit pattern is correctly drawn or not, instead of drawing the circuit pattern. Therefore, in the electron optic system 25 of Fig. 2, the electron beam from the electron gun 21 is converged by a converging lens 22, such as an electromagnetic lens, into a predetermined beam size, and then irradiated onto any desired region of the sample by means of the deflector 23. Therefore, an appropriately converged electron beam is irradiated onto a given region of the circuit pattern as shown in Fig. 3a. The beam diameter of the electron beam is adjusted by the electron optic system 25 so that the given region of the sample can be irradiated uniformly.

As shown in Fig. 3b, in the case of an X-ray mask as the sample, the substrate 26 is a thin film made of a material containing elements having a relatively small atomic weight, such as SiC. On the substrate 26, an absorber 27 made of a material containing an element having a relatively large atomic weight, such as gold or tantalum is patterned for absorbing X-rays. When the electron beam is irradiated onto the mask S, electrons incident on the absorber 27 are scattered by the heavy element thereof so as not to pass through the mask. On the other hand, the substrate 26 is in the form of a thin film having thickness about 2 $\mu$m, and electrons incident of the substrate are hardly scattered at all. Therefore, the spreading width of the scattered electron beam is quite small and most electrons pass through the substrate 26.

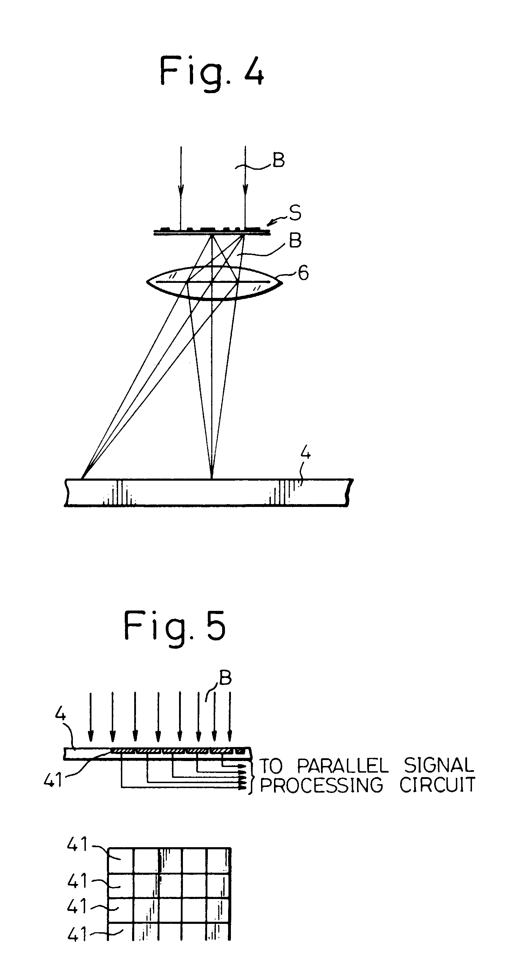

Accordingly, as shown in Fig. 3C and 4, only the electrons transmitted through the substrate 26 form the expanded image on the detecting means 4 with an appropriate electron optic system 6. Since the transmission electrons are detected, dust, which does not significantly affect X-rays and is erroneously detected as a defect in the conventional method for detecting the secondary or backscattered electrons permits the electron beam to pass without absorbing it significantly so as not to cause a detection error.

Thus, the electron beam B generated in the electron beam generating means 2 and shaped is irradiated onto the sample S. Then, the transmission electrons containing two dimensional information on the sample are projected on the detecting means 4 through the electron optic system 6 to form the pattern image T on the detecting means 4.

In the detecting means 4 as shown in Fig. 5, a plurality of detectors 41, such as semiconductor detecting elements formed by PN junction elements, are arranged in horizontal alignment in one or two dimensional directions. Each of the detectors receives electrons transmitted through the inspecting sample S and generates an electrical signal corresponding to the intensity of the received electrons.

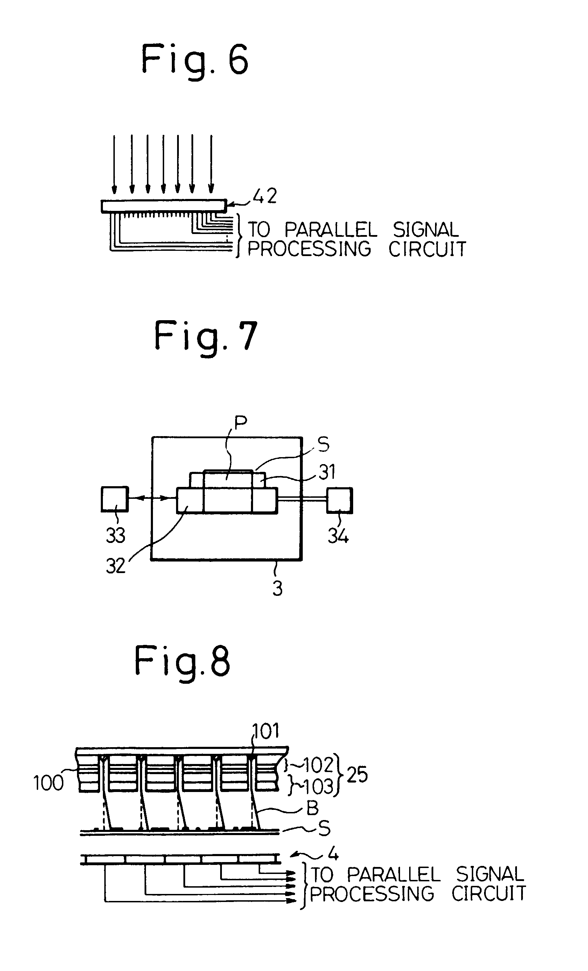

On the other hand, as the detecting means 4, a channel plane 41, such as that illustrated in Fig. 6, can also be employed.

In this case, electrons entering the channel are boosted to enhance the S/N ratio. As set forth above, the pattern thus formed can be obtained as a two dimensional image.

Each of the detection signals generated by the detecting means 4 is subject to processing, such as binarization, simultaneously or in parallel formation, by the signal processing portion 5 and transmitted to a memory section (not shown) or so forth and stored therein as a digital image signal. Subsequent processing following the image processing is similar to that performed in the conventional mask inspection apparatus. For example, it is possible to compare the image information of the same patterns of two chips to detect a difference therebetween to determine the presence of a defect. As an alternative, the defect can be detected by comparing obtained data with design data.

In the movable support means 3 shown in Fig. 7 in terms of one example, the sample is fixed to the sample stage 31. The sample stage 31 is rigidly fixed to an XY stage 32. Within the sample stage 31 and the XY stage 32, openings P are formed for passing electrons therethrough. The XY stage 32 is designed to be driven by means of an external driving motor 34 through a ball screw of so forth.

The foregoing discussion has been provided for the case in which the inspecting sample to be subject to the pattern inspection is a mask or the like, which permits the electron beam to pass therethrough. However, the same principle can be equally implemented for the case in which the inspecting sample S is a wafer or reticle having a substrate with a thickness of several mm and thus non-transmissive of electrons, by using secondary electrons.

In such a case, as shown in Fig. 1b, the detecting means 4 is disposed between the movable support means 3 supporting the inspecting sample S and the electron beam generating means 2. The detectors 41 of the detecting means 4 are of course directed toward the movable support means 3. Other constructions should be understood as equivalent to those of the configuration shown in Fig. 1a.

Furthermore, in the above-mentioned apparatus, the electron beam B generated by the electron beam generating means 2 may be scanned over the inspecting sample S appropriately by means of a deflection means. Such construction may be combined with the movable support means 3 so that the predetermined pattern T can be rapidly detected with high sensitivity for a small defect and high accuracy.

In order to satisfy the requirement for processing a large amount of data for efficiently inspecting samples having high circuit density and high package density, the present invention uses a plurality of the electron beam generating means 2.

A first embodiment of the invention is illustrated in Fig. 8. As can be seen, the electron beam generating means 2 employed in the embodiment in Fig. 8 has a construction such that the electron beam generating means 2 _per se_ is divided into a plurality of sub-devices; each sub-device at least includes an electron emitter 101, a converging electrode 102, and a deflection electrode 103 formed in the laminated construction.

The electron beam generating means 2 in Fig. 8 has a silicon substrate 100. In the silicon substrate, an electron emitter section 101 of silicon or hexagonal boron lanthanum is formed. On the same or separate silicon substrate, a plurality of layers of silicon oxide ($SiO_2$) and a polycrystalline silicon layer are appropriately formed, and the converging electrode 102 and the deflection electrode 103 are formed together with a hole for allowing electrons to pass through with a fine processing technology. Then, the sub-assemblies thus formed are combined to obtain a multi-construction electron beam generating means 2.

The electron beams generated in the electron beam generating means 2 of the shown embodiment have an identical diameter to each other and are adapted to irradiate the predetermined area of a plurality of regions on the sample S uniformly.

In order to practically implement the pattern inspection apparatus according to the invention, in view of efficiency of inspection, a plurality of electron beam generating means 2 are employed as illustrated in Fig. 8. These can be arranged in one dimensional direction or in two dimensional directions.

It should be appreciated that the number of rows or columns and the arrangement pattern of a plurality of electron beam generating means 2 are not critical and can be determined in any number and any pattern depending upon the intended application.

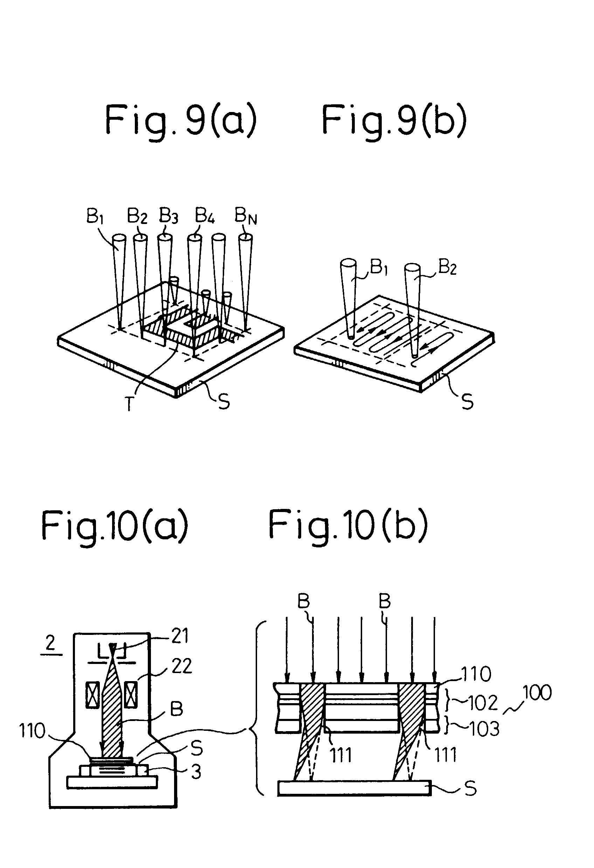

Particularly, as shown in Fig. 9a, on the circuit pattern T formed on the sample S, a plurality of electron beams B1, B2, B3, B4 ... Bn are irradiated simultaneously so that respective electron detecting elements 41 of the detecting means 4 may detect the transmitted or backscattered secondary electrons. Therefore, by employing the multi-construction electron beam generating means 2, a fine and large amount of pattern information can be quickly and accurately obtained for enhancing efficiency of inspection.

On the other hand, when a plurality of the electron beam generating means 2 are employed, each electron beam generating means 2 may be designed to scan the electron beams B1, B2, ... over a predetermined region by the deflection electrode 103.

By employing such a construction to permit scanning of the electron beam, it becomes possible to enable quick inspection for any configuration of circuit pattern on the inspecting sample S by using scanning of the electron beam in combination with horizontal shifting of the movable support means 3.

In order to positively form a plurality of electron beams B, another construction of the electron beam generating means 2 as illustrated in Fig. 10 can be employed.

Namely, in the shown embodiment, a fine construction substrate 110 having the converging electrode 102 and the deflection electrode 103, excluding the electron emitter 101 as the electron gun, are fabricated. The fine construction substrate 110 is disposed between the electron beam generating means 2 composed of the electron gun 21 and the optical system 22 as shown in Fig. 10(a) and the movable support means 3. Then, the electron beam injected from the electron gun and having an uniform diameter formed by the optical system 22 passes a given number and given configurations of a plurality of electron beam passing holes 111 so that a plurality of the electron beams can be irradiated on the surface of the inspecting sample S.

In addition, by controlling deflection of the electron beams passing through the electron beam passing holes 111 respectively by means of the converging electrode 102 and the deflection electrode 103, a plurality of regions on the inspecting sample can be scanned simultaneously.

In the method set forth above, part of the circuit pattern on the inspecting sample S can be inspected at one time. As set forth above, by using the deflection means for scanning the electron beam in combination with the operation of the movable support means 3, the area to be inspected at one inspecting operation can be expanded.

Therefore, in the present invention, after inspection of the part of the region of the pattern T on the inspecting sample S is completed, the movable support means 3 is shifted by means of the XY stage 32 to shift the irradiating region of the electron beam.

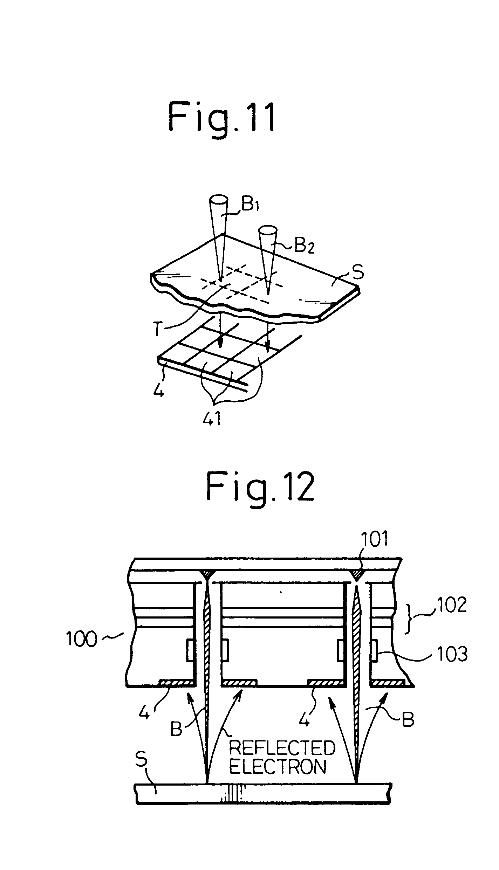

As shown in Fig. 11, the detecting means 4 has a size corresponding to a small region. In each region, the electron detecting elements 41 of the detecting means 4 detect the presence and absence of the transmission electron in synchronism with scanning the electron beam to obtain pattern information at respective positions on the mask.

Fig. 12 shown the pattern inspection apparatus according to the present invention, which is designed for detecting the secondary electron or the backscattered electron from the mask or wafer on which the electron beam is irradiated. In the shown construction, the detecting means 4 having a plurality of electron detecting elements 41 is formed in the substrate 100, on which the electron beam generating means 2 is provided.

In the method of patten inspection according to the present invention, each of the electron detecting elements 41 is coupled with a corresponding the electron beam so as to detect the secondary electron or the backscattered electron from the irradiating position of the corresponding electron beam. Since the electron beam and the electron detecting elements 41 are driven integrally, the secondary electron or the backscattered electron from the adjacent beam will be detected as mere noise. Therefore, degradation of a S/N ratio due to scattering of the adjacent electron beam will never occur. The detection signal from each detecting element 4 is transmitted to the signal processing section and subject parallel image processing, such as binarization. Then the resultant digital image signal is stored in the memory section. The image processing to be subsequently performed is similar to that in the conventional inspection apparatus.

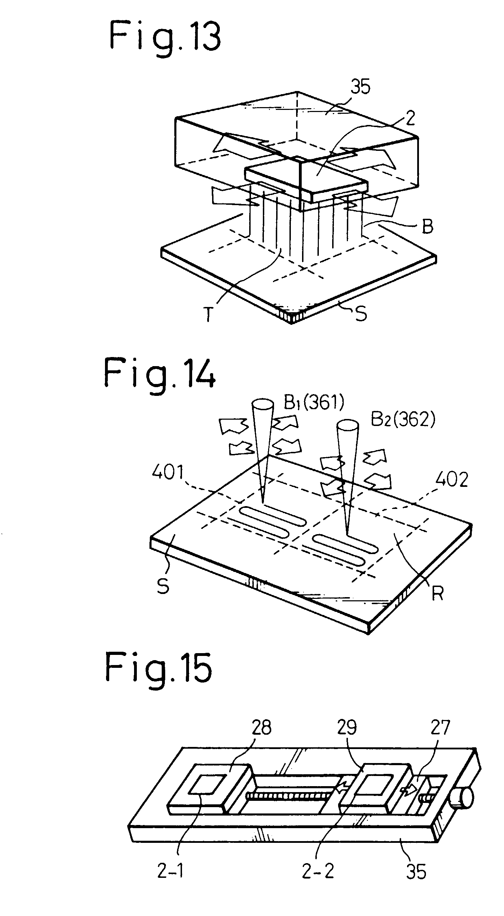

In the present invention, it is possible to oscillate the electron beam generating means 2 per se within a predetermined region or to shift the electron beam generating means 2 in a two dimensional directions by a driving section 35, instead of employing the deflection means 103 in the electronic beam generating means set forth above, as shown in Fig. 13. With such a construction, as shown in Fig. 14, the electron beam B1, B2 can be irradiated in the predetermined region of the inspecting sample uniformly in a relatively wide range. Therefore, by driving the electron beam B to shift at high speed with a predetermined appropriate pattern by the driving section 35. This makes provision of the deflecting optical system 103 the electron beam generating means 2 unnecessary.

The electron beam generating means 2 is mounted on an oscillation stage that is driven to oscillation in a substantially small range at high speed by the driving section 35. When a piezoelectric oscillation actuator, such as a piezoelectric element or the like is employed for driving the oscillation stage, high speed oscillation in at a frequency of several 10 Khz in a range of several 100 um can be realized.

In the practical construction of the pattern-inspection apparatus according to the present invention, two of the above-mentioned pattern inspection mechanisms are provided for respective chips. Two pattern inspection mechanisms are at identical positions so that the same positions of the chips can be inspected. The positions of the pattern inspection mechanisms are variable depending upon the size of the chips to be inspected. Namely, as illustrated in Fig. 15, the electron generation means 2-1 and 2-2 are mounted on fine adjustment stages 28 and 29 respectively, which can be adjusted by a slide 27 for adjusting the distance between stages. On the other hand, on the stage supporting the inspecting samples, it is possible to apply the piezoelectric oscillation element. Furthermore, it may also be possible to cause shifting of the electron beam in the X direction by the above-mentioned mechanical scanning means and to scan the electron beam in the Y direction by an electrostatic deflection electrode 103 by means of an electrostatic deflection electrode (or vis versus).

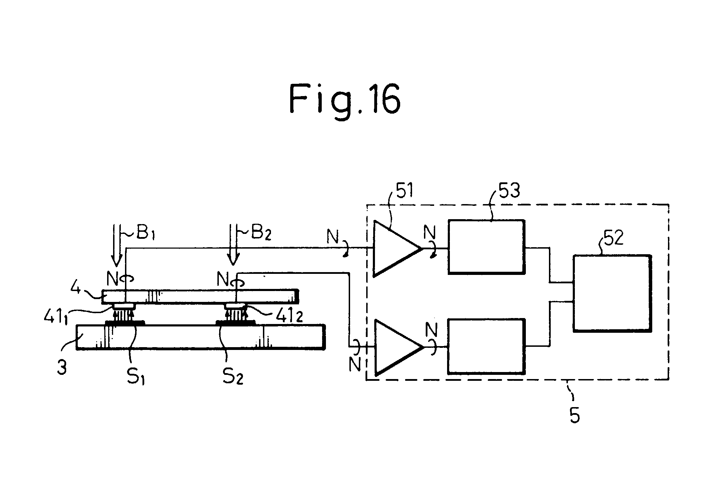

In the present invention, as shown in Fig. 16, the inspecting samples S1 and S2 are mounted on the movable support means 3. Respective samples S1 and S2 are irradiated by the electron beams in unison so that respective corresponding electron detecting elements $41_1$ and electron detecting elements $41_2$ detect the the secondary or backscattered electron reflected from the irradiated position to output the detection information. The detection information is processed by the amplifier 51 and the image memory 53 and then compared in the detecting signal processing circuit 52.

Fig. 17 shows a plan view illustrating a practical method for performing a comparison of the detected patterns between the samples S1 and S2. When the chip pattern T1 of the inspecting sample S1 and the chip pattern T2 of the inspecting sample S2 are compared, the first electron beam generating means 2-1 and the second electron beam generating means 2-2, between which fine adjustment of the distance is effected, are scanned according to the predetermined scanning pattern by the driving section 35. If addition, if required, by providing fine oscillation, a predetermined deflection is provided for the electron beam B. As an alternative, employing the deflection means incorporated in the electron beam generating means, the predetermined deflection is provided for the electron beam B. By this, the pattern T in the predetermined region can be completely scanned and inspected.

With the practical embodiments set forth above, by irradiating at least one electron beam to the predetermined region on the inspecting sample, such as the mask or wafer or so forth, and by using the secondary electron or backscattered electron reflected from the sample or the transmitted electron transmitted through the sample, the defect in the circuit pattern on the inspecting sample can be detected with satisfactorily high sensitivity and resolution and at high speed. Accordingly, it becomes possible to provide the pattern inspection device that can be adapted to an increase of the fineness of the circuit pattern and to an increase in the package density.

In addition, when the inspection is performed for the inspecting sample, such as X-ray mask or so forth, by detecting the transmission electron, erroneous detection caused by dust can be successfully prevented to enhance the accuracy of the inspection.

Next, another embodiment of the pattern inspection apparatus according to the present invention will be discussed.

With the foregoing embodiment, the object of the present invention can be attained. However, on the other hand, in the case of the pattern inspection apparatus that employs a plurality of parallel scanning electron beams, the respective electron flow entering the corresponding electron flow detecting sections may interfered with the electrons from the adjacent irradiating region. This degrades the S/N ratio at the boundary region between the adjacent irradiating regions.

Therefore, by solving the above-mentioned problem, the effect of the present invention can be improved. Therefore, the shown embodiment has been proposed for attaining a shortened inspection time, and as well, to provide enhanced S/N ratio at any electron irradiating regions.

As set forth above, when a single electron beam is irradiated on the predetermined region of the inspecting sample for detecting the backscattered electron or the secondary electron generated by the irradiation of the electron beam by the corresponding backscattered electron or secondary electron detecting section, the secondary electron generated in the adjacent inspecting region can be superimposed on the backscattered or secondary electron from the region to be inspected. In such a case, an error, such as when the presence of the pattern is detected even though a pattern is not presented in the inspecting region, can result.

For avoiding superimposition of the secondary electron from the adjacent inspection region, various proposal have been made. In the shown embodiment, a plurality of electron beams are modulated into a pulse so that the pulse period of respective electron beams irradiating respective adjacent inspection regions are differentiated from each other. Upon detection of the secondary electron at a respective inspection region, the pulse period of the electron beam is synchronized so that only the synchronized pulse is processed for inspection. As an alternative, by calculating the pulse width of the electron beam for detecting the occurrence of the electron beam having a specific pulse width, measurement of the secondary electron of the corresponding inspection region takes place in response to the occurrence of the specific pulse width of the electron beam.

In addition, in the shown embodiment, the electron beams consisting of pulses having different periods are subject to a time-division based multiplexing process so that the secondary electron of the region to be inspected is measured in synchronism with the specific pulse.

Also, in the shown embodiment, a plurality of electron beams are respectively modulated and composed to form a modulated electron beam. With this modulated electron beam, the secondary electron beam of the region to be inspected is measured in synchronism with the specific pulse width.

Namely, in the shown embodiment, the electron beam is processed to form a pulse or to be modulated so that a time difference is provided in the measuring timing of the secondary electron at respective inspection regions to prevent the influence of a secondary electron from adjacent inspection regions.

In the present invention, the modulating process includes a time sharing process and a detection method as well as an ordinary modulation process.

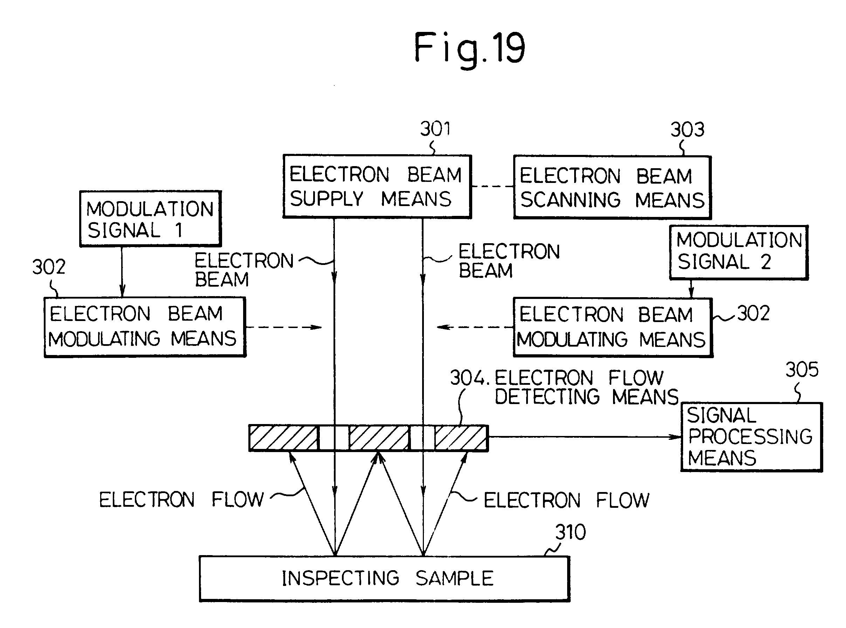

Fig. 19 shows an embodiment of the pattern inspection apparatus according to the present invention, showing a principle. In Fig. 19, the reference numeral 301 denotes an electron beam supply means; 302 denotes an electron beam modulating means; 303 denotes an electron beam scanning means; 304 denotes an electron flow detecting means; 305 denotes a signal; 1 denotes a processing means, and 310 denotes the inspecting sample. It should be noted that the shown embodiment is directed to an example employing two electron beams. Also, the electron beam scanning means 303 is shown as a mechanical scanning means for shifting the electron beam supply means 301.

In order to accomplish above-mentioned object, the pattern inspection apparatus according to the present invention comprises an electron beam supply means (30) for supplying electron beams respectively irradiated on a plurality of irradiating regions of an inspection sample (310), an electron beam modulating means (302) for modulating respective electron beams to moduled signals having mutually distinct signal patterns, an electron beam scanning means (303) for shifting the irradiating position of respective electron beams in order, an electron flow detecting means (304) for detecting the electron flow from the inspecting sample (310) generated by the electron beam and including information relating to the construction of a respective irradiating region, and a signal processing means (305) for extracting a signal representative of the construction of a respective irradiating region from the output signal of the electron flow detecting means (304).

Respective electron beams supplied through the electron supply means 301 is modulated to the mutually distinct patterns of moduled signals by the electron beam modulating means 302. The moduled signals of the electron beams are scanned on respective irradiating regions on the inspecting sample via the electron beam scanning means 303. The electron flow generated at respective irradiating regions by irradiation of the electron beams are gathered by incidence to the common electron current detecting means (304) and subsequently input to the signal processing means 305. The signal processing means 305 thus derives signals indicative of the construction of respective irradiating regions.

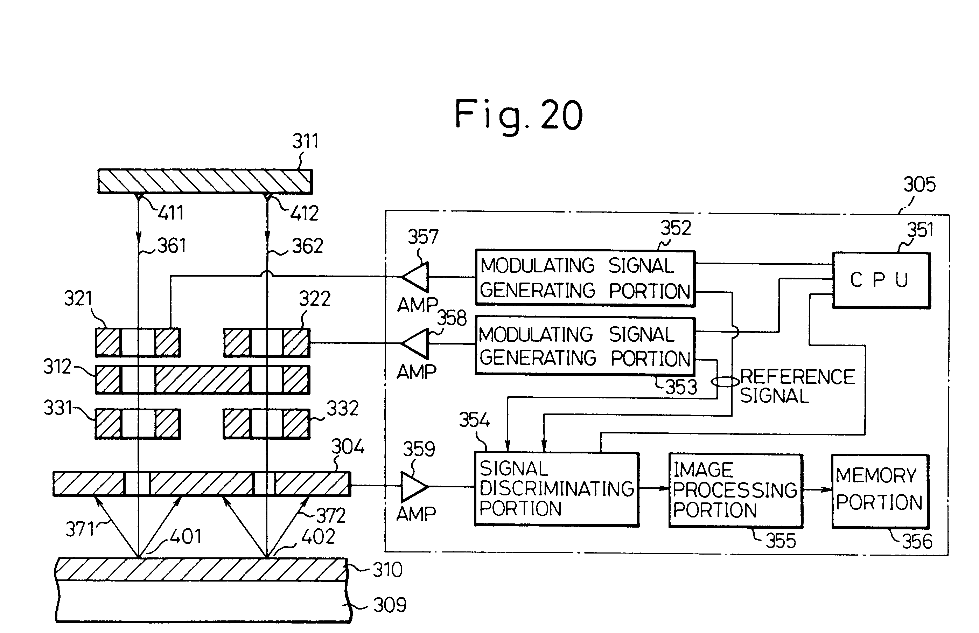

Further detailed discussion about the foregoing embodiment will be given hereafter with reference to the drawings. Fig. 20 shows, in the form of a diagram, the construction of the shown embodiment of the pattern inspection apparatus. In the drawings, an electron generating element 411 forming a part of the electron beam supply means includes a plurality of electron emitters 411 and 412 on the common plane. The electron emitters 411 and 412 emit electron beams 361 and 362. The electron beams 361 and 362 are modulated by modulating electrodes 321 and 322 that form the electron beam modulating means and receive an modulating signal from the signal processing section 305.

The electron beams 361 and 362 passes a common converging electrode 312 that converges respective electron beams in a respective fine area, and deflection electrodes 331 and 332 provided for respective electron beams 361 and 362 to reach the inspecting sample 310. The converging electrode 312 forms a part of the electron beam supply means. The deflection electrodes 331 and 332 scan respective irradiating regions 401 and 402 of the inspecting sample by shifting the electron beams 361 and 362 in order within the irradiating regions 401 and 402.

The inspecting sample 310 is fixed on the sample stage 309. The sample stage 309 is adapted to be shifting in X, Y and Z directions via a XYZ stages. The XYZ stages are designed to be driven by respectively corresponding drive motors through ball screws or so forth. When scanning the electron beam on respective irradiating regions 401 and 402 the deflection electrodes 331 and 332 are completed, the x-y stage motor is driven for scanning another irradiating region of the inspection sample 310.

On the upper portion of the inspecting sample 310, the common electron flow detecting section 304 is provided to commonly detect the backscattered electron 371 and 372 generated by irradiation of the electron beams 361 and 362 on respective irradiating regions 401 and 402. The output of the electron current detecting section 304 is input to the signal processing section 305.

The signal processing section 305 comprises a CPU 351 for controlling the overall pattern inspection apparatus, modulated signal generating section 352 and 353 for providing the modulating signals for respective modulating electrodes 321 and 322 via amplifiers 357 and 358, a signal discrimination section 354 for discriminating the configuration signals from the irradiating regions 401 and 402 taking respective modulated signals from the modulating signal generating sections 352 and 353 as reference signals, an image processing section 355 for receiving the output of the signal discriminating section 354 to convert the information contained therein into a binary image signal, and a memory section 356 for storing the binary image signal.

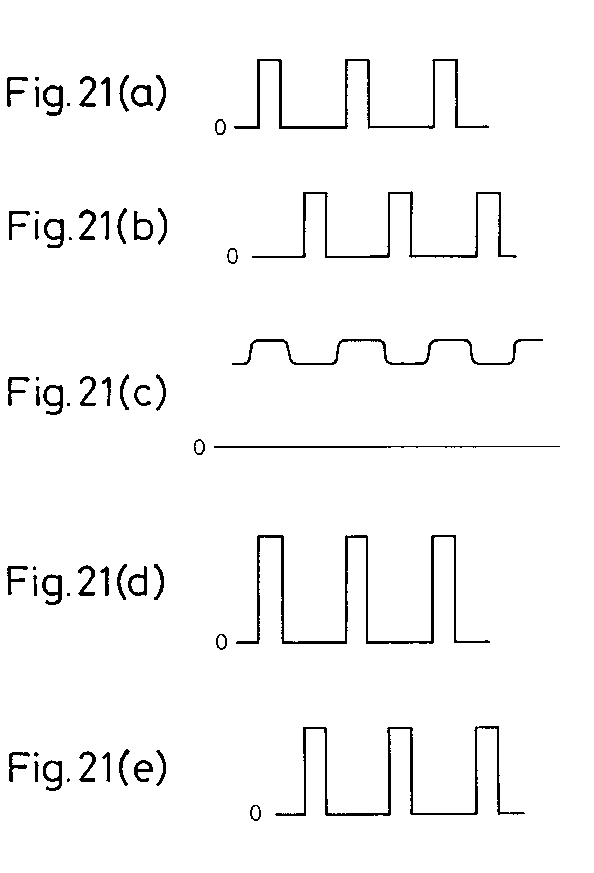

Fig. 21 shows waveforms of the signals to be used for discussion about respective signals in a pattern inspection apparatus. In this embodiment, the modulating means forms pulses of the sequence of the electron beam for alternatively using two pulses having mutually different pulse phases. In the present invention, the modulated method includes a method for making a pulse signal from a continuous beam. The modulated pulse signals illustrated in Figs. 21(a) and 21(b) are pulse signals having mutually similar pulse frequencies and peaks thereof appear in alternative fashion. Namely, the shown embodiment is directed to the example of signal processing in time-division multiplexing.

The signal of the electron flow gathered in the electron detecting section 4 by inciding thereto from respective irradiating regions is illustrated in Fig. 21(c) as the input for the signal discriminating section. Namely, when the modulated pulse signal 1 is H level, the input signal for the signal discriminating section discriminates the signal as the configuration signal of the irradiating region 401. On the other hand, when the modulated pulse signal 2 is at H level, the signal discriminating section discriminates the input as the configuration signal of the irradiating region 402.

In the signal discriminating section 354, by employing the pulse signal 1 as the reference signal, the output as illustrated in Fig. 21(d) may be obtained as the configuration signal of the irradiating region 401. On the other hand, by employing the pulse signal 2 as the reference signal for discrimination, the output 2 illustrated in Fig. 21(e) is obtained as the configuration signal of the irradiating region 402. The amplitude of these outputs represents the pattern at respective irradiating regions 401 and 402. These signals are thus discriminated by the signal discriminating section 354 and converted into the digital signals by the image processing section 355 parallel to each other.

The output of the image processing section 355 is stored in the memory section 356 as digital image information. By a signal processing section 305, which is not shown and following the memory section 356, the conventional signal processing is performed for implementing a pattern inspection.

An example is given to the signal frequency to be used. When a period, in which each electron beam is processed and modulated into a pulse signal, and namely, the period in which the electron stays on the pulse generating electrode, is 500 nsec, approximately 2 Mhz is used as the frequency of the pulse signal. In such a case, assuming the total number of irradiating regions to be irradiated in parallel formation according to the present invention is 100, and by employing time sharing multiplexing, the pulse width of a respective modulated pulse signal becomes 500 nsec./100 = 5 nsec. Accordingly, in such time sharing multiplexing, as pattern information of the inspecting samples, it becomes possible to perform an inspection for 2M × 100 every second. Namely, 200 pixel/seconds is possible.

On the other hand, instead of using the time sharing multiplexing, it is possible to use pulse signals having the same frequency and mutually different pulse width, and even in this case, the signal discrimination taking the moduled signals as reference signals is similar to the former embodiment.

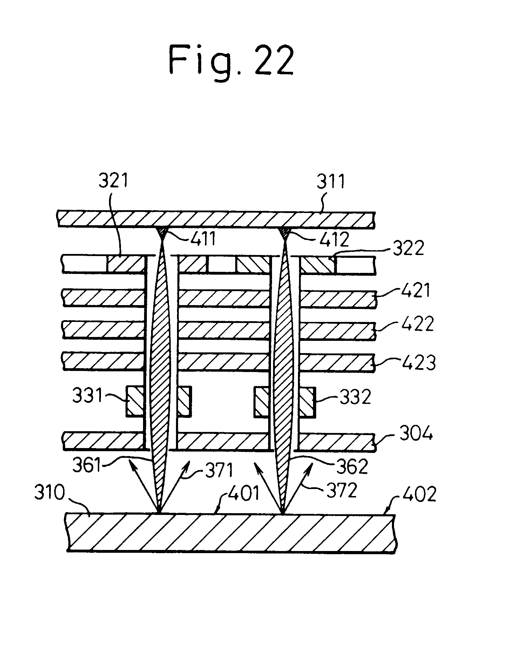

Fig. 22 shows a section of the detailed construction of the electron beam irradiating portion in the embodiment of Fig. 20. In Fig. 22, shows an electron beam generating section 311 forming the electron beam supply means, the converging electrodes 421 to 423 forming three stage lens, and modulating electrodes 321 and 322 disposed therebetween. On the side of a traveling direction of the electron beam of the converging electrodes 421 to 423, the deflection electrodes 331 and 332 are provided.

In the construction of the electron beam irradiating portion, the electron beam generating section 311, the modulating electrodes 321 and 322, the converging electrodes 421 to 423 and the deflection electrodes 331 and 332 are preferably formed on the silicon substrate employing fine processing technology. Such construction has been reported in G. W. Jones et al. "Microstructure for Particle beam Control", J. Vac. Sci. Technol. page 2023 to 2027, B6(6), Nov/Dec 1988, for example.

As shown in Fig. 22, the converging electrode is formed by three stage electrostatic lens 421, 422 and 423 arranged in order of traveling direction of the electron beams 361 and 362. The front stage electrostatic lens 421 is set at high potential with respect to the electron beam generating section 311 and commonly used as an output line for extracting an electron from the electron emitters 411 and 412.

The rear stage electrostatic lens 423 is maintained at equal potential to the front stage electrode 421. The intermediate electrode 422 is maintained at a different potential to the electrodes 421 and 423. The three stage electrostatic lens converge the electrons emitted from the electron emitter 411 and 412 and having a tendency to be scattered the same into the electron beam for irradiating a substantially small area.

The modulating electrodes 321 and 322 modulates electron beams 361 and 362 into pulses according to the modulating signals. In such a case, peaks of the modulating signal become equal potential to the electron beam generating section 311 to permit the electron beam, and the bottom of the pulse of the modulating signal becomes negative to shut the front stage electrostatic lens 421 from the electron beam generating section 311 to block a emission of the electron to control the generated electron amount from the electron beam generating section 311.

The deflection electrodes 331 and 332 are provided the same scanning signals so that scanning voltages are applied between the deflection electrodes respectively in opposing X and Y directions. By deflecting the electron beams simultaneously in the same direction according to the scanning voltage, scanning of respective irradiating regions occurs simultaneously.

The manner of scanning is illustrated in Fig. 14. The electron beams 361 and 362 converging at the irradiating regions 401 and 402 by the effect of the converging electrodes are shifted in four directions parallel to the irradiating surfaces of respective irradiating regions 401 and 402 of the inspecting sample by respectively corresponding deflection electrodes, as illustrated by arrows so that all regions in the irradiating regions 401 and 402 can be scanned.

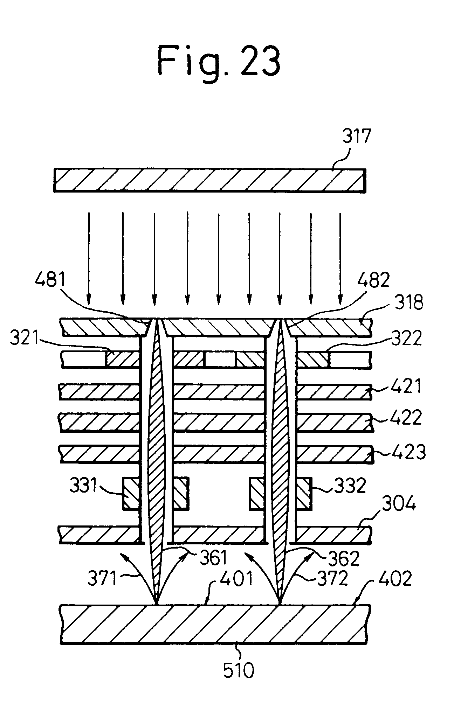

Fig. 23 is a section showing another construction of the electron beam irradiating portion in the pattern inspection apparatus according to the present invention that corresponds to that illustrated in Fig. 10. In Fig. 23, the electron beam generating section 317 is differentiated from that shown in Fig. 22 and has an electron supplying means 317 for supplying uniform electrons, and a shielding plate 318 having fine apertures 481 and 482 at positions corresponding to respective irradiating regions for introducing electron beams therethrough. An accelerating voltage is charged at the position between the shielding plate 318 and the front stage electrostatic lens 421 for accelerating the electron. The other construction is the same as that of Fig. 22.

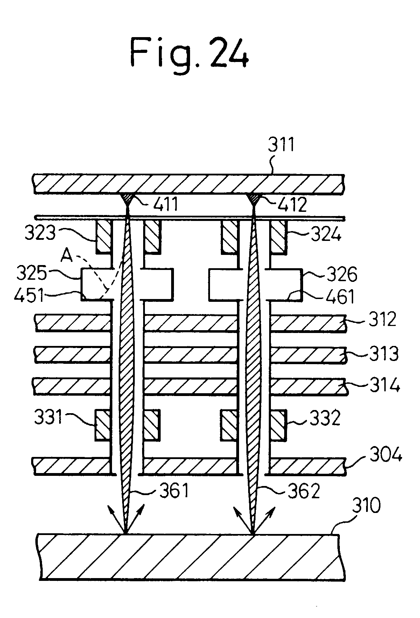

Fig. 24 is a section showing the electron beam irradiating portion in the third embodiment of the pattern inspection apparatus according to the present invention. In the shown embodiment, in place of the modulating electrodes 321 and 322 for modulating the electron beam as illustrated in Fig. 22, a deflection modulating electrodes 323 and 324 for deflecting the electron beams 361 and 362 in a direction perpendicular to the traveling direction as illustrated by broken line A, and a passing control section 325 and 326 for blocking the deflected electron beam by blocking walls 451 and 461 are provided. The other construction is the same as that of Fig. 22. The signal waveform in this embodiment is similar to that shown in Fig. 21 and therefore discussion thereof is omitted.

In the shown embodiment, by sequentially deflecting the axis of the electron beam transversely, a pulse form electron beam is irradiated on the irradiating region.

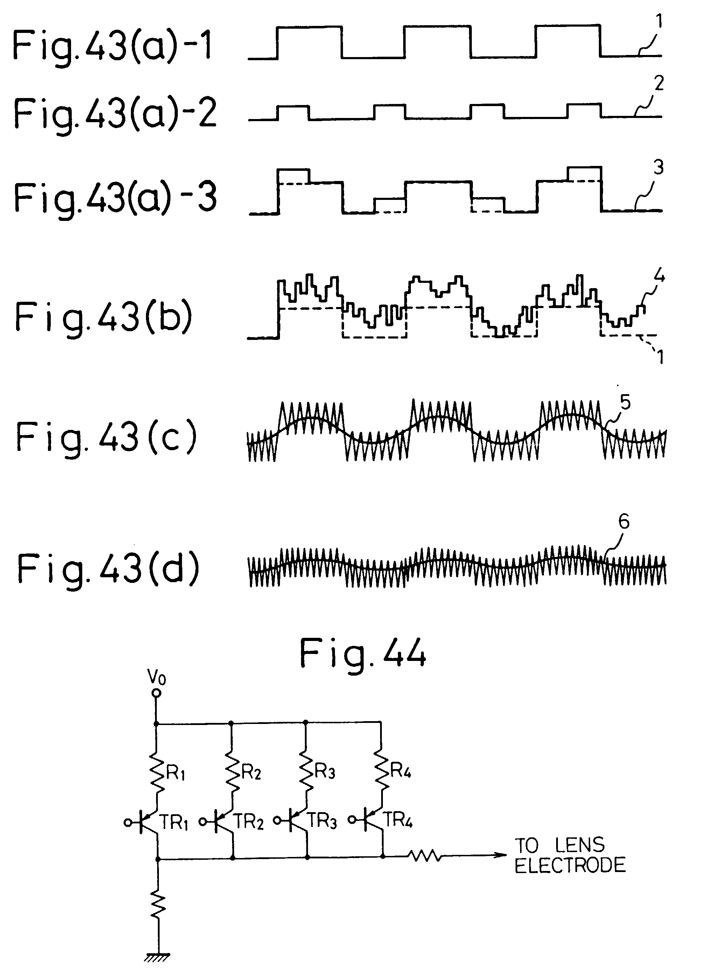

Fig. 43 shows signal wave forms used in another embodiment of the modulating method of the present invention in which each one of main pulse wave signals is modulated by adding thereto a plurality of another pulsed signals each having a frequency different from each other and the main pulse wave signal per se can be discriminated from the detected signal, a plurality of the pulse wave signals each having a frequency different from each other are integrated in the main pulse wave signal by tuning the main pulse wave signal with the same frequency as the main pulse wave signal originally possesses.

For example, Fig. 43 (a)-1 shows a wave form of the main pulse wave signal in a beam used in the present invention while Fig. 43 (a)-2 shows a wave form of the noise caused by an interference signal generated by adjacent pulse wave signal beams.

The former pulse wave signal has a frequency different from that of the latter and Fig. 43 (a)-3 shows a wave form of a modulated pulsed wave form in which the main pulse wave signal 1 is modulated by the noise pulse wave signal 2 and thus a detector detects the pulse wave form 3 in that the noise is incorporated thereinto.

Note, that in Fig. 43 (a)-3, a dotted line represents an true pulse wave form of the main pulse wave signal 1.

Fig. 43 (b) shows a pulse wave form of a modulated pulsed wave form in which the main pulse wave signal 1 is interfered by a plurality of noise pulse wave signals---, each having a different frequency from each other.

Note, that in this embodiment, the pulse wave signal as shown in Fig. 43 (b) is formed by modulating the main pulse wave signal 1 by a plurality of noise pulse wave signals.

Fig. 43 (c) shows a modulated wave form obtained from the pulse wave form as shown in Fig. 43 (b) by passing it through a band-pass filter having the same frequency as the main pulse wave signal originally possesses as a center of the band used and a continuous line 5 represents the wave form of the modulated wave form of the pulse wave signal 1 in which both of the high frequency components and low frequency components are deleted from the final wave form.

Note, that the wave form as shown in Fig. 43 (c) for example, represents a signal level showing that the pulse wave signal 1 detects white patterns, i.e., the fact that patterns are existing.

On the other hand, Fig. 43 (d) shows a modulated wave form obtained from another pulse wave form generated in a condition in which no pattern exists by the same way as explained above, and a continuous line 6 represents a signal level showing that the pulse wave signal detects black patterns, i.e., the fact that no pattern is existing.

Accordingly, the fact that whether or not the pattern exist on the substrate, can be discriminated by detecting the difference of amplitudes of the two separate wave forms thereof.

With the shown construction, a plurality of irradiating regions can be scanned by the electron beams simultaneously enabling high speed inspection. Also, interference of the adjacent electron beams can be successfully prevented to obtain the configuration signals with an enhanced S/N ratio. Therefore, the shown embodiment of the pattern inspection apparatus can perform accurate inspection in a short inspection period.

Although the foregoing embodiment attains a remarkable gain in the improvement of the efficiency of inspection and avoids mutual interference of adjacent electron beams, there is the following unsolved problem.

Namely, the foregoing pattern inspection apparatus according to the present invention, is composed of a plurality of electron guns, beam extracting electrodes, converging electrodes, deflection electrodes. When respective electron guns or respective electrodes have a tolerance in production, a slight variation is induced in the characteristics of the electron beams so as to cause a fluctuation of the focus points of the electron beams. In some cases, the focus point is set in front of or behind the irradiating surface to cause focus error at the image to be inspected. This problem is encountered not only in pattern inspection but also in the drawing of a pattern employing the electron beam exposure device. To solve this problem, the electron beams emitted from a plurality of electron guns have to be uniformly irradiated on the inspecting surface. The following embodiment of the pattern inspection apparatus proposes a solution for this problem by comparing each electrode with a preliminarily provided reference electrode to individually adjust the characteristics thereof and make it consistent with that of the reference electrode.

The following is a discussion for the embodiment of the pattern inspection apparatus according to the present invention.

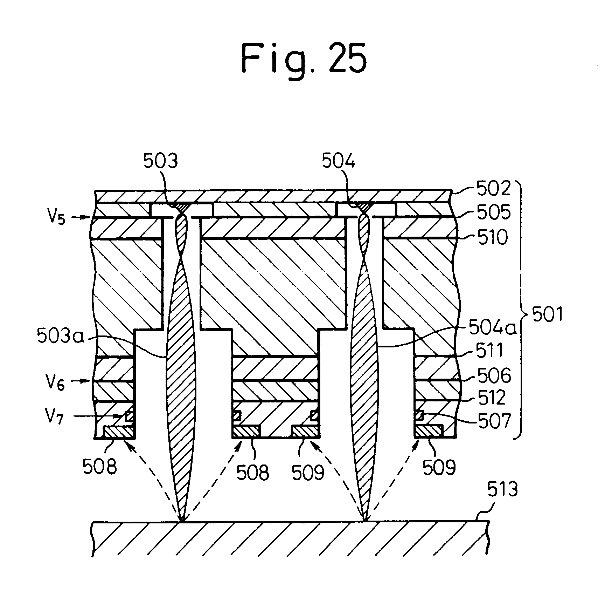

Fig. 25 shows the construction of the major portion of the embodiment of the pattern inspection apparatus according to the invention. In Fig. 25, the reference numeral 501 denotes the electron beam generating means. The electron beam generating means 501 has a silicon substrate 502, on which a plurality of (two are shown in the drawing) electron emitters 503 and 504 are formed of silicon, metal, such as Ta or the like, or lanthanum boride or the like. Below the electron emitters 503 and 504, an extraction electrode 505, a converging electrode 506, a deflection electrode 507 and detectors 508 and 509 are laminated in order. The reference numeral 510 denotes an anode; 511 and 512 denotes grounding electrodes; 513 denotes an inspecting sample, such as an exposure mask or the like, on which a fine pattern (omitted from illustration) is formed.

From the electron emitters 503 and 504, charged particle beams (electron beams) 503a and 504a are emitted 504a having a beam current corresponding to the electrode voltage $V_5$ of the extraction electrode 505. The electron beams 503a and 504a is then converged with a convergence ratio corresponding to the electrode voltage $V_6$ of the converging electrode 506. Subsequently, the electron beam 503a and 504a are deflected at an deflection angle corresponding to the electrode voltage $V_7$ of the deflection electrode 507 and thus irradiated onto the sample 513 in the form of a spot.

Then, the backscattered electron or the secondary electron (illustrated by broken line) is discharged from the surface of the sample in response to the irradiation of the electron beams 503a and 504a. These emitted electrons are caught by the detectors 508 and 509 and converted into electric signals, for example, an X-ray mask, and a greater amount of emitted electrons are emitted from the electron beam absorber than from the mask membrane forming the sample 513, because the material (gold, tantalum and other elements having a large atomic weight) used for the electron beam absorber has a higher generation ratio of backscattered electrons or the secondary electrons than the material (silicon or other elements having a small atomic weight) used for the mask substrate.

Accordingly, by simultaneously irradiating a plurality of electron beams 503a and 504a for unitarily processing the outputs of the detectors 508 and 509 for respective electron beams, a fine and large amount of pattern data of the pattern formed on the surface of the sample 513 can be inspected rapidly and accurately. Also, when the apparatus is applied to a pattern drawing apparatus, a circuit pattern having a fine and large capacity for pattern data can be rapidly and accurately drawn.

However, in the above-mentioned electron beam apparatus, since common electrodes are provided for a plurality of electron beams, it can happen that spot diameters of the electron beams can be slightly differentiated, the beam axes can be slightly offset, or the deflection angles do not become precisely coincident with each other, because of mechanical tolerance of the electromatnetic optical systems for respective electron beams. Therefore, in view of an improvement of making the electron beam characteristics coincident with each other with high precision, there still remains a technical problem to be solved.

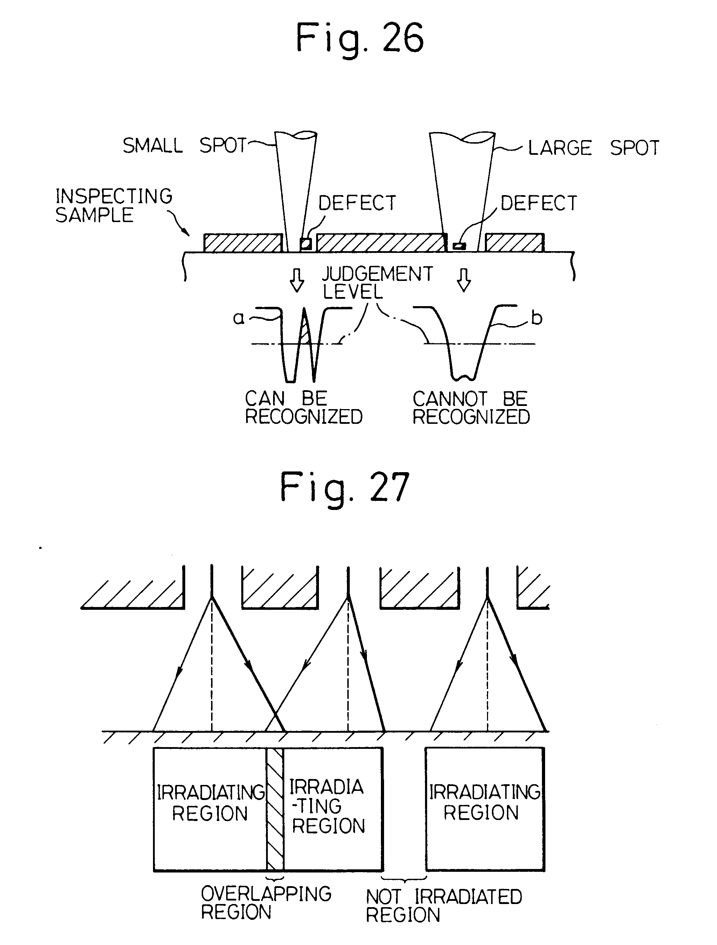

Fig. 26 illustrates an abstract of a problem arising due to a fluctuation of the spot diameter of the electron beam. Though a defect in the circuit pattern that can be detected with smaller spot, it is often difficult to detect the same with a larger spot. The illustrated waveforms a and b represent the detected intensity of the backscattered electron or secondary electron reflected from the sample surface or the transmission electron passing through the sample. Although it is not illustrated, by providing the detector at the back side of the sample, the transmission electron can be caught and converted into an electron signal to obtain one dimensional information of the transmission path in addition to two dimensional information of the sample. In the case of a large spot, the signal intensity at the defective portion becomes small to make it difficult to recognize the defect.

Fig. 27 is an explanatory illustration showing a problem arising due to a fluctuation of the deflection angle. When the deflection angle becomes excessive, the electron beam can enter the adjacent irradiating region to create an overlapping region to form a multiple detection region. On the other hand, when the deflection angle is too small, a non-irradiating region can be left between adjacent irradiating regions creating a non-inspected region.

Such a problem will occur even when the electron beam system is applied to a pattern drawing apparatus. Namely, the fluctuation of the spot diameter may degrade the precision of patterning. On the other hand, the fluctuation of the deflection angle may cause degradation of the precision of pattern drawing positions.

Therefore, the present invention proposes an electron beam system that enables the adjustment of characteristics of a respective individual electron beam and thus to make the characteristics of the overall electron beams uniform with precision.

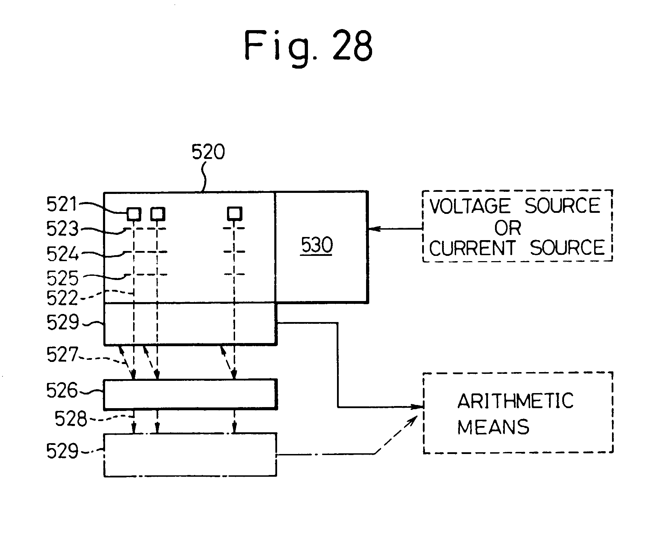

Fig. 28 shows one embodiment of the electron beam system implementing the invention set forth above. As shown in Fig. 28, on a common substrate 520 or separated substrate arranged on the same plane, a plurality of electron emitters 521 are formed. For each of the individual electron emitters 521, an extraction electrode 523 for extracting a charged particle beam 522 from the electron emitter, a converging electrode or a converging coil 524 for providing a converging ratio corresponding to the electrode voltage or an energization current, a deflection electrode or deflection coil for providing a deflection angle corresponding to the electrode voltage or an energization current to the charged particle beam, a detector 529 for detecting the secondary electron or the backscattered electron 527 reflected from the surface of the sample 526 or an transmission electron 528 passing through the sample 526, and an adjusting means for all or part of the electrode voltage or energization current provided for the extraction electrode 523, the converging electrode or converging coil 524 and the deflection electrode or deflection coil 525, are provided.

In the shown embodiment, the electrode voltage or the energization current for each of the charged electron beams can be adjusted independently. For example, by adjusting the electrode voltage of the converging electrode 524, the spot diameter of the charged particle beam can be adjusted. On the other hand, by adjusting the electrode voltage of the extraction electrode 523, the beam current is varied to adjust the spot diameter. As an alternative, by adjusting the electrode voltage of the deflection electrode 525, the charged particle beam axis can be adjusted.

Therefore, the overall electron beam characteristics can be unified with high accuracy.

The practical embodiment of the electron beam system according to the invention will be discussed herebelow.

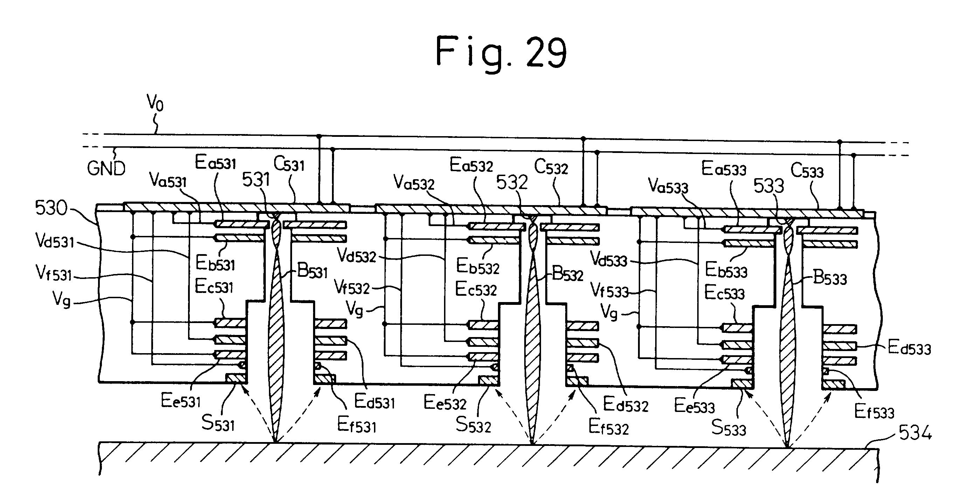

Figs. 29 to 35 shows the practical embodiment of the electron beam system that is directed to application of the pattern inspection apparatus.

In Fig. 29, the reference numeral 530 denotes one or more substrates of multi-layer structure. For the substrate 530, a plurality of (three are shown in the drawing) of electron emitters 531 to 533 formed of a metal, such as or silicon, Ta or the like or lanthanum boride or the like are formed. It should be appreciated, that the substrate 530 can be a common substrate for the electron emitters 531 to 533, or as an alternative can be an individual independent substrate for each of the electron emitters 531 to 533. In the further alternative, the substrate 530 can be formed by laminating and holding a plurality of substrates. However, in the case of the individual independent substrate, the individual substrates have to be arranged on a common plane and integrated by being fixed to each other.

Below, respective electron emitters 531 to 533, an extracting electrodes $Ea_i$ (i is 531, 532 and 533, same in the following), an anode $Eb_i$, a first grounding electrode $Ec_i$, a converging electrode $Ed_i$, a second grounding electrode $Ee_i$, a deflection electrode $Ef_i$ and a detector $S_i$ are provided in order. These elements are provided exclusively for corresponding to one of the electron emitters 531 to 533.

Here, discussion will be provided for major electrodes. The extraction electrode $Ea_i$ is adapted to extract a charged particle beam (electron beam) $B_i$ having a beam current corresponding to given electrode voltage $Va_i$ from the electron emitter 531 (or 532 or 533). The converging electrode $Ed_i$ converges the electron beam by generating an electric field having an intensity corresponding to the charged electrode voltage $Vd_i$. The deflection electrode generates an electric field corresponding to the charged electrode voltage $Vf_i$ for providing a deflection angle for the electron beam. Other electrodes (anode electrode $Eb_i$, the first grounding electrode $Ec_i$ and the second grounding electrode $Ee_i$) are adapted to assist in the function of the extraction electrode $Ea_i$, or form an electric filed distribution for converging electrons between the converging electrode. For these electrodes, the same potential of electrode voltage Vg (grounding potential) is provided.

The above-mentioned construction merely shows the typical construction in number of electrodes, layout of the electrodes and distribution of the charged voltages, and should not be regarded as essential for implementing the invention. Furthermore, although, the discussion is provided for the example employing electrostatic convergence and electrostatic deflection, the drive type should not be specified as the electrostatic type but can be electromagnetic convergence and electromagnetic deflection. Also, it is possible to use an electrostatic driving type and an electromagnetic driving type in combination. However, in the case that the electromagnetic type driving is employed, the converging electrode and the deflection electrode should be replaced with the converging coil and the deflection coil. Also, the driving power to be applied to these elements is an engergization current.

The detector $S_i$ provided for respective electron beam $B_i$ is adapted to catch the backscattered electron or the secondary electron emitted from the surface of the sample 534, such as the X-ray exposure mask or the like, to mark for aligning the sample 534 to be exposed or a correction unit pattern, which will be discussed later, and to convert into an electric signal. The electric signal output from respective detectors $S_i$ contains information representative of the configuration of a fine portion of the electron beam absorber (not shown) on the sample 534, i.e., the circuit pattern in a fine portion. Accordingly, the two dimensional information of the sample 534 can be reproduced from all of the electric signals. Therefore, the defective portion (white defect or black defect, for example) in the fine pattern can be accurately identified. Alternatively, although it is not illustrated, by providing the detector at the back side of the sample, the transmission electron can be caught and converted into an electron signal to obtain one dimensional information of the transmission path in addition to two dimensional information of the sample.

Here, the circuit $C_i$ for a respective beam formed by fine processing technology on the upper surface of the substrate has a function as the adjusting means, as set forth above, and adapted to generate necessary voltages $Va_i$, $Vd_i$, $Vf_i$ and Vg) by voltage divider resistors, for example.

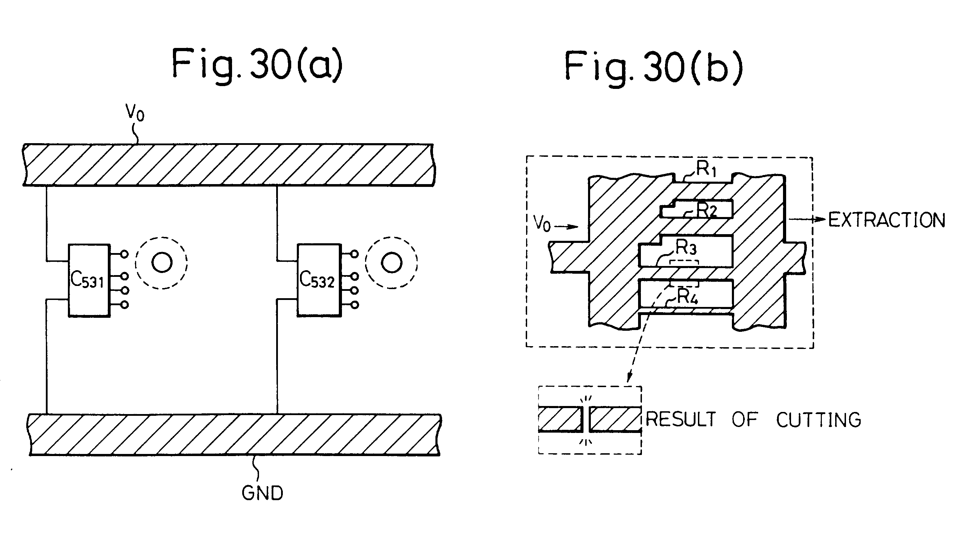

Fig. 30 shows the plan view of the circuit $C_i$ and the detail thereof. The power source voltage $V_o$ introduced into the circuit $C_i$ is taken out as $Va_i$, $Vd_i$ or $Vf_i$ through a parallel resistor network including several resistors ($R_1$, $R_2$, $R_3$ and $R_4$). By selectively cutting off the resistor elements, the voltage can be adjusted. As a method of voltage adjustment by a parallel resistor network is specific to the shown parallel resistor network but can be a series resistor network or combination thereof. Also, instead of cutting off the selected resistor, an equivalent voltage adjustment can be done by adding a selected resistor(s). Furthermore, respective elements in the resistor network can be formed by transistors.

As a suitable device for cutting off and connecting the fine pattern, a mask repair device disclosed in "Precision Mechanics Paper" (Vol. 53, No. 6, pages 15 to 18) June 5, 1987, Precision Mechanics Association), for example, in which high luminous FIB (Focused Ion Beam), higher than or equal to $1A/cm^2$ having a beam diameter less than or equal to 0.1 μm, is generated for correction (cutting out of black defect or connection by deposition of the material vapor) of the pattern defect (black or white defect) on the photo mask by the FIB.

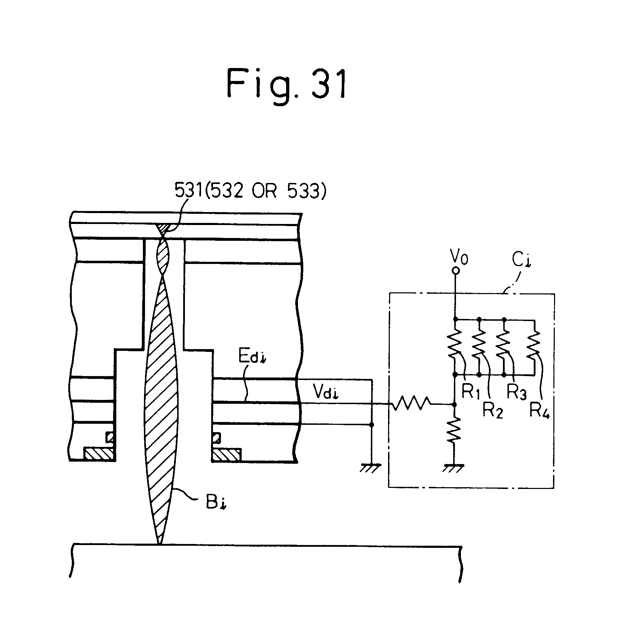

Referring to Fig. 31, by selectively cutting off respective resistor elements $R_1$ to $R_4$ of the circuit $C_i$, the electrode voltage $Vd_i$ for converging the electron beam $B_i$ can be appropriately adjusted by applying it to the converging electrode $Ed_i$ and varying the voltage division ratio of the power source voltage $V_0$. By this, the converging ratio of the electron beam $B_i$ converged by the converging electrode $Ed_i$ can be adjusted to adjust the spot diameter.

On the other hand, although it is not illustrated in the drawing, by adjusting the electrode voltage $Va_i$ to be applied to the extraction electrode $Ea_i$, the amount of the beam current of the electron beam $B_i$ can be adjusted independently since there is a correlation between the beam current and the spot diameter.

Furthermore, though it is not illustrated, by adjusting the electrode voltage $Vf_i$ to be supplied to the deflection electrode $Ef_i$ the beam axis and the deflection angle of the electron beam $B_i$ can be adjusted.

Fig. 31 is an illustration of a connection when an electrode voltage Vdzi of a converging electrode Edzi is adjusted.

As set forth above, since the characteristics of each of the electron beams can be adjusted independently of each other, the characteristics of the overall electron beam can be unified. Therefore the shown embodiment is successful in solving the problem concerning the inconsistency of beam axes or deflection angles.

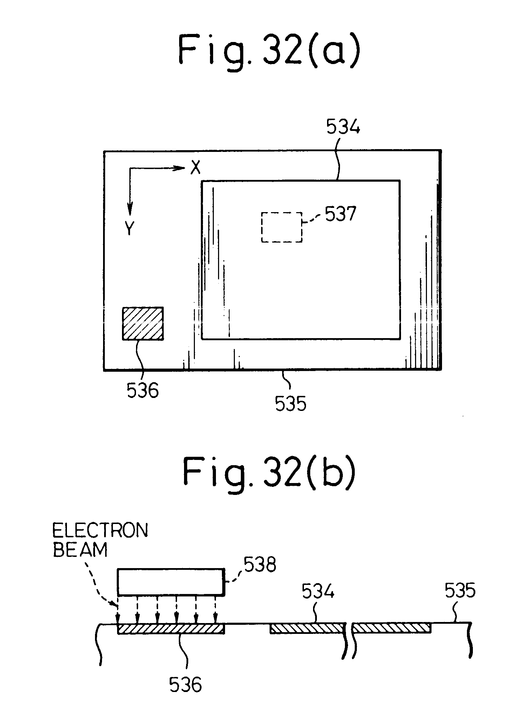

Next, a preferred example for detecting the fluctuation of the characteristics of the electron beam $B_i$ will be discussed. Fig. 32(a) shows a plan view of a table 535 that is movable in X-Y directions when mounting the sample 534. At the predetermined position of the table 535, a reference pattern section 536 is fixedly provided so that it can be placed within the irradiating region of a plurality of electron beams by shifting the table 535. Fig. 32(b) shows a side elevation wherein the reference pattern portion 536 is positioned within the irradiating region 537 of the electron beams. A plurality of electron beams discharged from an electron beam generating means 538, including a plurality of electron emitters, are irradiated on the reference pattern portion 536.

In the reference pattern portion 536, unit patterns (element having a large atomic weight is used) in the number corresponding to the number of the electron beams and precisely designed are arranged in regular arrangement. The backscattered electron or secondary electron is discharged from respective unit patterns and circumferential non-patterned portions, or the transmission electron passing through respective unit patterns and the circumferential non-patterned portions are detected by the detector $S_i$.

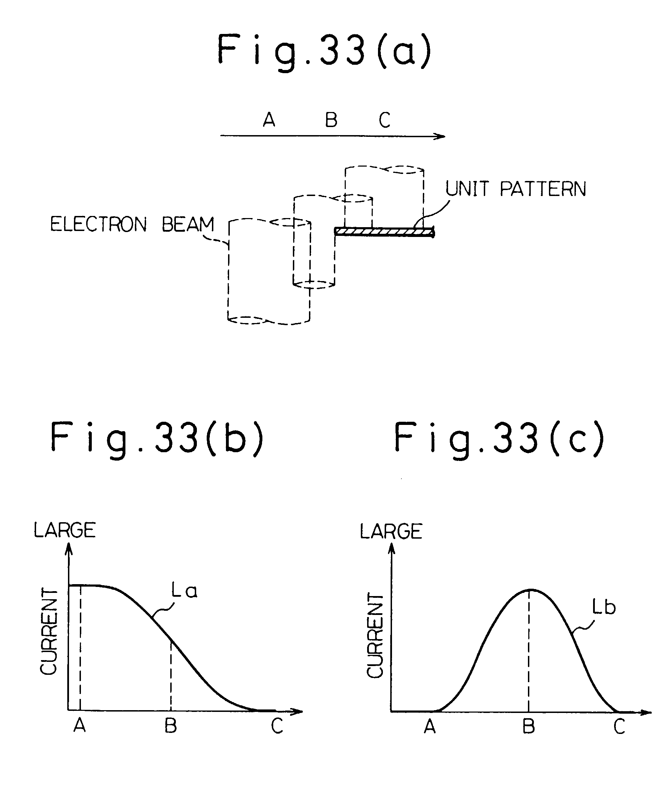

Fig. 33 shows when the electron beam is irradiated on the single unit pattern and the circumferential non-patterned portions. It is assumed that the relative positional relationship between the electron beam and the unit pattern is shifted from the position A to a position B and then from the position B to a position C by deflecting scan or fine shifting of the table 535. At the position A, all of the electron beam is irradiated on the non-patterned circumferential portion. Therefore, the largest amount of the transmission electron passes through the non-patterned portion. At the position B, the electron beam irradiates approximately half of the unit pattern. At this time, the amount of transmission electrons becomes lesser than that the position A. On the other hand, at the position C, the electron beam fully irradiates the unit pattern. Therefore, no transmission electrons is obtained. Fig. 33(b) is a graph illustrating a variation of the beam current representative of the variation of the transmission electron while shifting from the position A to the position C. As can be seen, the line La shows a variation of the beam current, in that the beam current is initially large and abruptly decreases across the position B and then becomes 0. Fig. 33(c) shows a graph Lb illustrated a differentiated value of the line La. As can be seen, the differentiated value becomes 0 at both ends and becomes maximum at the position B. With a width of the differentiated value curve, Lb (generally half value width) represented the width of the electron beam and the spot diameter. Such a measurement is called a knife edge method.

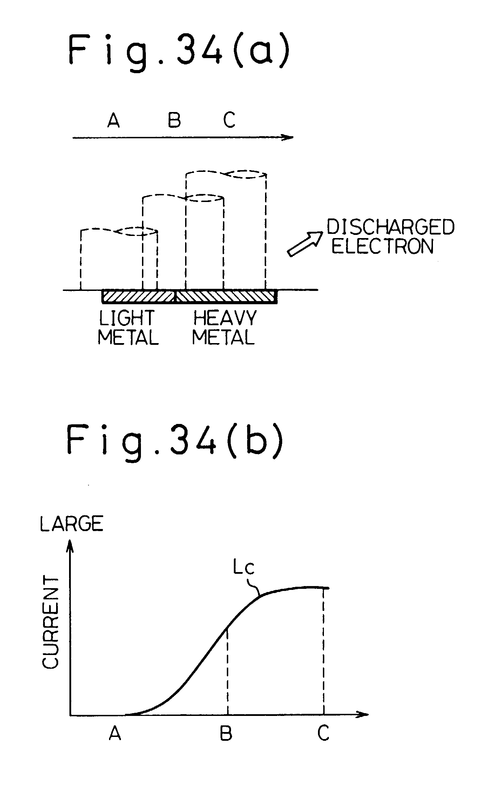

Fig. 34 illustrates another manner. In Fig. 34(a), for the reference pattern formed by a combination of the light element, having a relatively light atomic weight a heavy element, such as tantalum, the electron beam is irradiated in the same manner. Then, because of the difference of atomic weight, the difference is induced in the generation of the backscattered electron or the secondary electron so that the current variation curve Lc as shown in Fig. 34(b) is obtained while shifting from the position A to the position C. Similarly to the knife edge method, the curve swiftly varies across the position B. Then, with the differentiated values, a differentiation curve similar to Fig. 33(c) can be obtained for measuring the spot diameter.

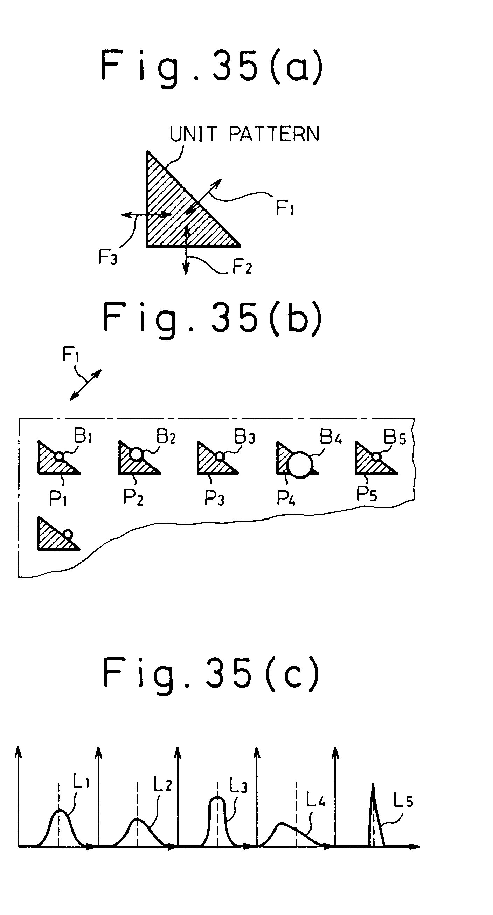

The foregoing examples of a practical measurement of the spot diameter is adapted for a single electron beam. In the modification, the spot diameters of a plurality of electron beams can be measured through the process as illustrated in Fig. 35.

Fig. 35(a) illustrates a preferred plane configuration of the unit pattern. Here, by utilizing the triangular unit pattern, the electron beams are scanned in the three directions $F_1$ to $F_3$ respectively perpendicular to the three edges of the triangle. By this method, the pure circular spot diameter of the electron beam can be accurately measured. This method also permits a measurement of longer and shorter axes of an elliptic spot causing astigmatism.

Now, it is assumed that for respective unit patterns $P_1$ to $P_5$ forming the random unit pattern, the electron beams $B_1$ to $B_5$ respectively having different spot diameters are irradiated. The scanning direction is set to $F_1$. The differentiation curves of beam currents of respective unit patterns are shown in Fig. 35(c). $L_1$ shows the differentiation curve corresponding to the electron beam $B_1$. $L_2$ shows the differentiation curve corresponding to the electron beam $B_2$. Similarly, with respect to the electron beams $B_3$ to $B_5$, the differentiation curves $L_3$ to $L_5$ are obtained.

Comparing these curves $L_1$ to $L_5$, the curve $L_5$ corresponding to the electron beam $B_5$ having the smallest diameter has a minimum width and the highest peak. Conversely, for the $L_4$ corresponding to the electron beam $B_4$ having the largest spot diameter, the width attains maximum value and the peak attains the lowest value. The differences between the curve $L_5$ corresponding to the minimum diameter and other curves $L_1$ - $L_4$ correspond to the differences of the spot diameters. Accordingly, by utilizing such a difference in the curves, the correction values for the spot diameters for respective electron beams can be derived.

On the other hand, as can be seen from Fig. 35(b), the beam axis (spot center) of the electron beam $B_4$ is slightly offset from the center of the oblique edge. Accordingly, by using such an offset amount of peak position, the correction value for the offset of the beam axes for a respective electron beam can be derived.

As the unit pattern, it is possible to use the stencil type pattern with openings. In such a case, it is desirable to provide current measuring devices, such as Farady cups beneath the openings.

Furthermore, as the above-mentioned circuit $C_i$, it is also preferable to use a variable power source device, such as a voltage regulator circuit, a programmable power source or so forth. In the former case, the correction value for the spot diameter or the beam axis offset is provided for the reference voltage, and in the latter case, the correction value is provided for the program input.

Furthermore, in the case that the subject of correction is an electromagnetic type, the above-mentioned circuit $C_i$ becomes the current source. In such a case, using a resistance division, the current from the current source is appropriately divided. Namely, in the shown embodiment, the diameter and configuration of a respective beam can be independently measured so that the voltage or current to be applied to the electrode can be adjusted based on the result thereof, thereby making it possible to adjust the beam diameters of the electron beams substantially equal to each other.

In the above embodiment, a resistor network is used for precisely controlling the supplied voltage to the converging electrode but in the present invention, another switching means comprising a plurality of transistors also can be used as an alternative device instead of the resistor network.

Fig. 44 shows a switching means comprising a plurality of transistors TR1, TR2, TR3 and TR4, which can be used as a device for precisely controlling the supplied voltage to the converging electrode Edi.

Although in the previous embodiment, the control thereof can be carried out by cutting or connecting the resistor or resistors in the resistor network, in this embodiment, the control thereof can be carried out by controlling each one of these transistors in ON/OFF condition, respectively.

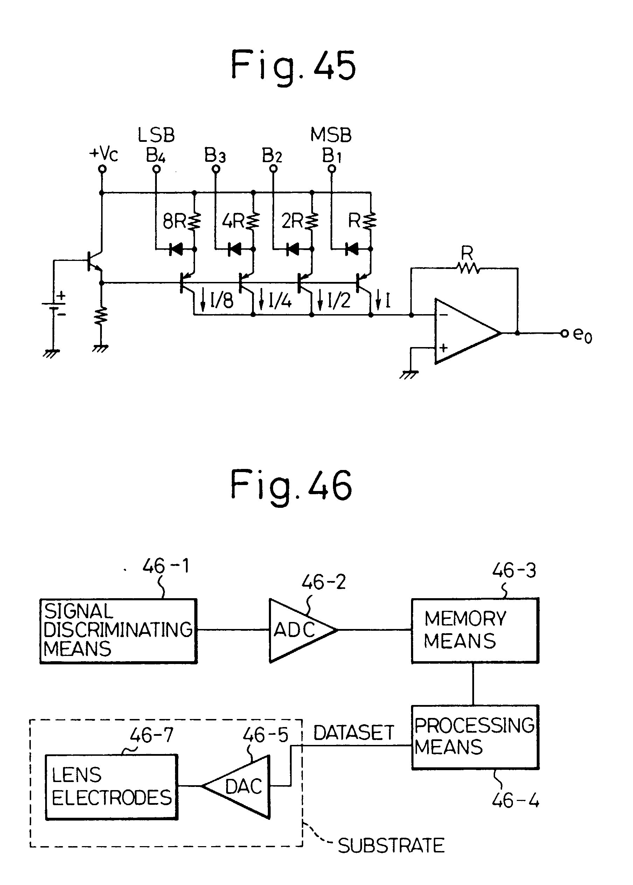

A digital-analog converter can be used as a typical type of this switching means and one of the representative circuit construction thereof is shown in Fig. 45 which is called as weighing constant current typed digital-analog converter.

In this circuit, the input terminals thereof comprise four bits B1 to B4 and thus the controlling operation can be carried out by applying any one of the control signals 1 or 0, respectively and accordingly the output thereof will be as follows;

$$VO = RI(B1/2 + B2/2^2 + B3/2^3 + B4/2^4)$$

Since there is an upper limit in the bit number in a DAC in practical use, the range of correction can be limited when the resolution is set excessively high. Therefore, it is desirable to use the adjustment by means of a DAC in combination with an adjustment by resistor. By this, a fine adjustment capability while maintaining a large adjustment range can be realized.

Further, in the present invention as explained in above embodiment, the adjusting the beam configuration can be carried out in real-time base and thus Fig. 46 shows one example of a controlling circuit for adjusting the beam configuration in real-time base.

The circuit comprises a signal discriminating portion 46-1 which corresponds to the signal discrimination portion 354 as shown in Fig. 20, a alanalog-digital convertors 46-2 and diginal-analog converters 46-5, a memory means 46-3, a processing means 46-4, and a plurality of lens electrodes 46-7.

In this circuit, when the signals output from each one of the detectors is discriminated by the signal discriminating portion 354 and then each one of the signal wave forms as shown in Fig. 35 is digitized by the analog-digital convertor 46-2 and stored in the memory means 46-3.

After that the processing means 46-4 processes the stored data to output a controlling data for adjusting the voltage of the conversion lens and it is output to the digital-analog convertor 46-7 provided on a substrate from which an analog controlling data is output to the lens electrode.

In the present invention, the variation of the deflection can also adjusted utilizing the above circuit.

As can be appreciated, according to the shown embodiment, since the characteristics of a plurality of electron beams can be independently adjusted, the characteristics of the overall electron beams can be precisely unified to avoid a fluctuation of the spot diameters, an offset of the beam axes of a fluctuation of the deflection angles.

In addition, the shown embodiment can effectively avoid interference of the backscattered electron between adjacent irradiating regions. Or, as an alternative, the degradation of the S/N ratio due to interference of the reflected beams from the adjacent region can be successfully compensated for with the following embodiment.

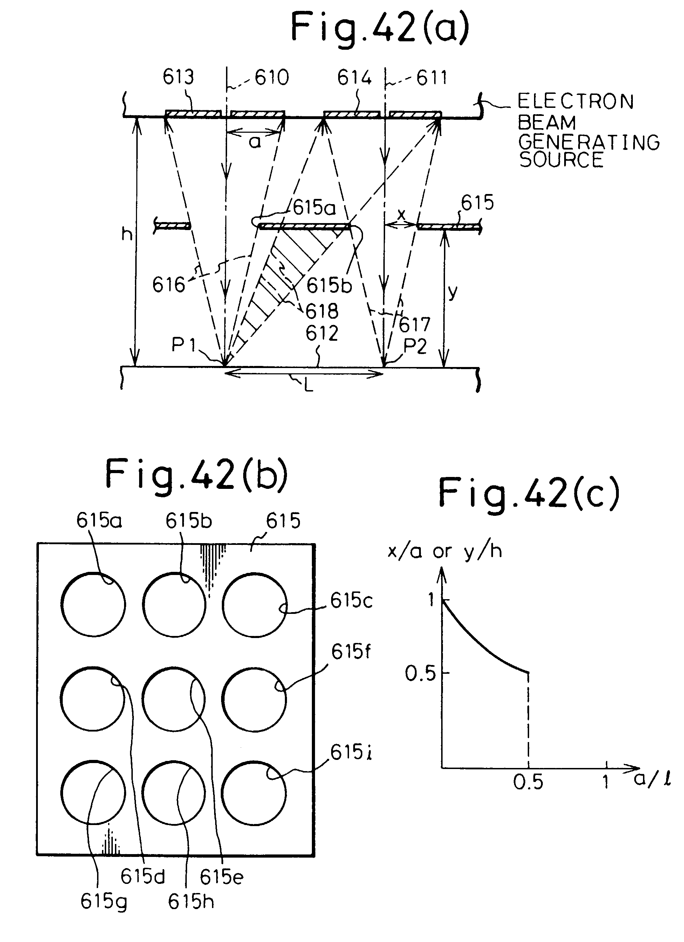

Namely, in order to improve the S/N ratio, the fourth aspect according to the invention is constructed as shown in Fig. 42. The shown embodiment of the pattern inspection apparatus according to the present invention includes a plurality of electron emitters arranged in a matrix fashion, each of which has a fine electrode with sharply headed tip end, a gate surrounding the tip end of the fine electrode, a converging electrode, a deflection electrode and a detector provided for each of the electron emitters, in which electron beams are simultaneously irradiated on the surface of the sample from the electron emitters parallel to each other; the backscattered electron or the secondary electron from the surface of the sample is caught by a detecting surface of each detector. Based on the amount of the backscattered electrons or secondary electrons, the condition of the surface of the sample is inspected. A mask having an opening with a predetermined internal diameter is arranged so that the center of the opening is aligned with the axis of the electron beam, at a position between the surface of the sample and the detecting surface of the detector and is determined based on the distance from the surface of the sample to the detecting surface and the size of the detecting surface.

The practical construction of the shown embodiment will be discussed with reference to Fig. 35.

In Fig. 42(a), the reference numeral 610 denotes an electron beam injected from one of a plurality of electron emitters; 611 denotes an electron beam emitted from the adjacent electron emitter. The two electron beams 610 and 611 as typically illustrated are irradiated to two points $P_1$ and $P_2$ mutually distanced by a distance L, simultaneously. Then, the electron (or secondary electron) are emitted from the points $P_1$ or $P_2$.

The reference numerals 613 and 614 denotes detectors provided in the vicinity of the outlets of the electron beams 610 and 611. These detectors 613 and 614 catch the backscattered electrons or the secondary electrons of corresponding electron beam on the surface having the given area to output the electric signal proportional to the amount of electrons caught.

Here, between the detectors 613 and 614 and the sample 612, there is provided a mask 615 with the openings. The mask 615 is formed with an opening in a number of circular openings (for example, nine 615a to 615i) corresponding to the number of the electron beams. The center of each circular opening (for example, 615a and 615b) is precisely aligned with the axis of the corresponding electron beams (for example 610 and 611).

The preferred position of the mask 615 with the openings is derived through the following manner. Namely, assuming that the distance from the surface of the sample 612 to the detectors 613 and 614 is h, the distance from the surface of the sample 612 to the mask 615 is y, the radius (corresponding to the size of the detecting surface) of the detecting surface of the detectors 613 and 614 is a, the radius of the openings 615a to 615i of the mask is x, the distance between the irradiating points $P_1$ and $P_2$ of the electron beams is L, the position of the mask 615 is selected so that the values of x and y satisfy that x/a or y/h is in a range of 1.0 to 0.5 and a/L is in a range of 0 to 0.5 (refer to Fig. 42C).

For example, when the distance between the detectors 613 and 614 is substantially 0, a/L becomes 0.5. Therefore, in such a case, the preferred position of the mask 615 is determined so that x/a or y/h becomes 0.5. Therefore, the position of the mask 615 is selected to place the circular opening having a radius x being approximately one half of the radius x of the detecting surface at approximately an intermediate position (y/h = 0.5) of the distance between the surface of the sample 612 and the detectors 613 and 614.

It should be appreciated that Fig. 42(a) shows an example for the case where a/L ≒ x/a ≒ y/h ≒ 0.5. In the shown example, the backscattered electron 616 backscattered from the point $P_1$ toward the detector 613 and the backscattered electron 617 backscattered from the point $P_2$ toward the detector 614 can pass through the circular openings 615a and 615b. However, the backscattered electron from the adjacent irradiating region, such as the backscattered electron 618 backscattered from the point $P_1$ toward the detector 614, is blocked by the non-opening portion of the mask 615. Accordingly, with the shown embodiment, entry of the backscattered electron from the adjacent irradiating region to the detector can be positively eliminated to enhance the accuracy of detection.

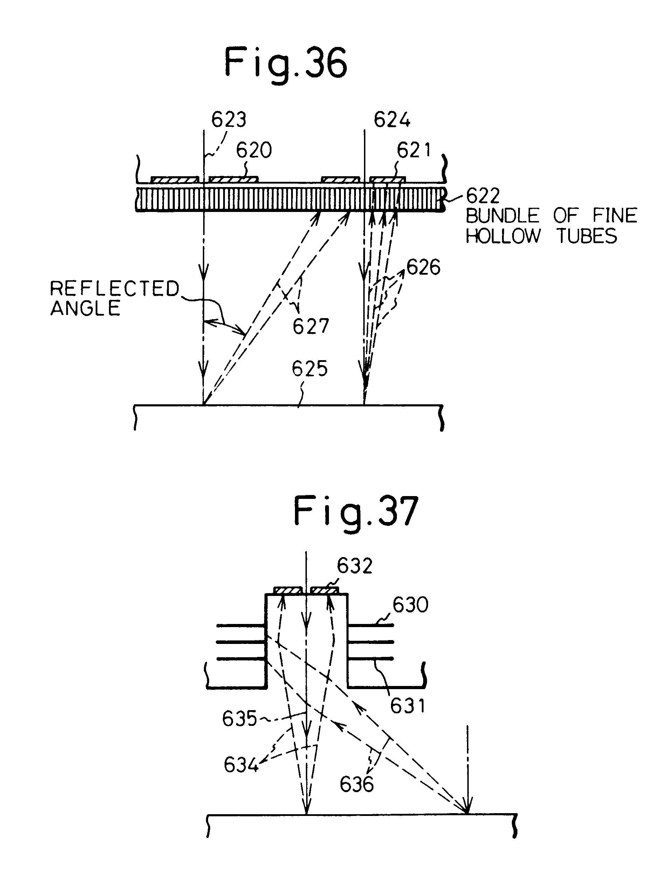

Next, a fifth embodiment of the present invention will be discussed. The fifth embodiment is illustrated in Fig. 36, in which, the shown embodiment of the pattern inspection apparatus comprises a plurality of electron emitters arranged in a matrix fashion; each of the electron emitters include a fine electrode with a sharp headed tip end and a gate surrounding the tip end of the fine electrode, a converging electrode, a deflection electrode and a detector provided for each of the electron emitters. The electron beams are emitted from the electron emitters simultaneously and parallel to each other and irradiate the surface of the sample. The backscattered electron or the secondary electron are caught by the detecting surface of the detectors with respect to each of the electron beams. Based on the amount of the backscattered electrons or the secondary electrons, caught the condition of the surface of the sample is inspected. A plurality of tin tubes having a predetermined length are provided in the orientation aligning the longitudinal axes thereof parallel to the axes of the electron beams.

In the practical construction, as shown in Fig. 36, a bunch of thin tubes is arranged in the vicinity of all the detectors (only shown 620 and 621 in the drawing). As said tin tube, a lead glass tube of 20 μmφ, which is used in an electron multiplier for MPC (microchannel plate) or so forth, is available. In the electron multiplier, the tube is slightly inclined relative to the axis of the electron beam so that the electrons collide on the inner periphery of the tube to provide energy corresponding to the potential of the inner wall for the backscattered electron. Conversely, in the shown embodiment, the tubes are provided precisely in alignment with the axis of the electron beam and no potential is provided for the inner wall.

With such an arrangement, the electron beams (typically 623, 624) can be irradiated on the sample 625 without any interference. On the other hand, only the backscattered electron having a reflecting angle smaller than or equal to a given angle is permitted to pass through the tube. Therefore, the backscattered electron from the adjacent irradiating region (which has too large a reflection angle) will never enter the tube. Therefore, interference of the backscattered electron from the adjacent irradiating region can be positively prevented. As can be appreciated, the reflection angular range to permit passing through the tube can be easily adjusted by selecting the diameter and length of the tubes.

Fig. 37 shows the sixth embodiment of the invention, in which the shown embodiment of the pattern inspection apparatus comprises a plurality of electron emitters arranged in a matrix fashion; each of the electron emitters includes a fine electrode with sharp headed tip end and a gate surrounding the tip end of the fine electrode, a converging electrode, a deflection electrode and a detector provided for each of the electron emitters. The electron beams are emitted from the electron emitters simultaneously and parallel to each other and irradiate the surface of the sample. The backscattered electron or the secondary electron are caught by the detecting surface of the detectors 632 with respect to each electron beam 630. Based on the amount of the backscattered electrons or the secondary electrons, caught the condition of the surface of the sample is inspected. The detectors are arranged between the converging and deflecting electrodes and the electron emitter.

Namely, as shown in Fig. 37, the detector 632 is positioned between the electron lens system, such as the converging electrode 630 or the deflection electrode 631 and the electron emitter.

With such construction, the backscattered electron 634 from the focus point of the electron lens system is deflected to be substantially parallel to the electron beam 635 in the principle of the convex lens and thus can easily reach the detector 632. Conversely, the backscattered electron 636 from the focus point of the adjacent electron lens system intersects with the axis of the electron beam 635 so as not to reach the detector 632. Therefore, with the shown arrangement, the precision in detection can be enhanced.

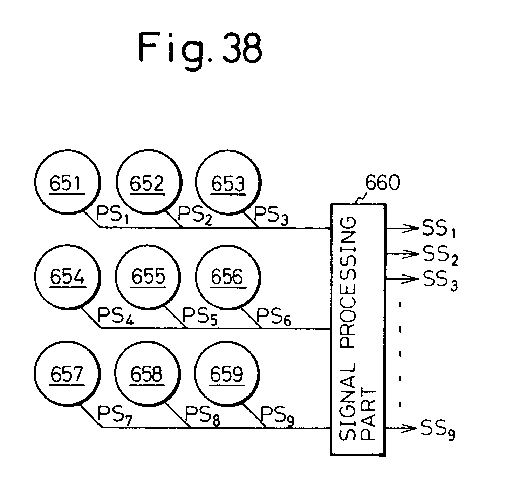

Figs. 38 to 41 show the seventh embodiment of the invention in which the shown embodiment of the pattern inspection apparatus comprises a plurality of electron emitters arranged in a matrix fashion; each of the electron emitters includes a fine electrode with sharp headed tip end and a gate surrounding the tip end of the fine electrode, a converging electrode, a deflection electrode and a detector provided for each of the electron emitters. The electron beams are emitted from the electron emitters simultaneously and parallel to each other and irradiate the surface of the sample. The backscattered electron or the secondary electron are caught by the detecting surface of the detectors with respect to each electron beam. Based on the amount of the backscattered electrons or the secondary electrons, caught the condition of the surface of the sample is inspected. The detected value of one of the detectors is processed by subtracting a value derived by multiplying respective signals of a plurality of surrounding detectors by a predetermined coefficient.

As shown in Fig. 38, the reference numerals 651 to 659 denote detectors provided corresponding to each electron emitter arranged in a matrix array. The detectors 651 to 659 are arranged in regular fine intervals. The detection signals $PS_{651}$ to $PS_{659}$ are provided to the signal processing section 660. The signal processing section 660 effects a predetermined signal processing to output corrected detection signals $SS_{651}$ to $SS_{659}$.

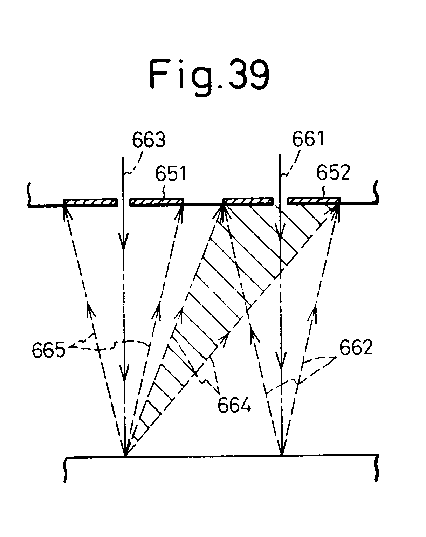

Fig. 39 is an illustration showing one embodiment of the pattern inspection apparatus according to the invention;

Here, considering two adjacent detectors (for example, detectors 651 and 652 of Fig. 38), one of the detectors (for example 652) catch the backscattered electron 662 of the electron beam 661 from its own electron beam generating source and also catches the backscattered electron 664 of the electron beam 663 from the electron beam generating source corresponding to the adjacent detector 651. Then, by the presence of the backscattered electron 664, the S/N ratio of the detector 652 is degraded. The S/N ratio of the detector 652 can be further degraded by the influence of a plurality of adjacent electron beams.

The detection signals $PS_{651}$ and $PS_{652}$ of the detectors 651 and 652 are expressed by the following equations:

$$PS_{651} = SS_{651} + N_{652} \qquad (1)$$

$$PS_{652} = SS_{652} + N_{651} \qquad (2)$$

where $SS_{651}$ is a value corresponding to the amount of backscattered electrons 665 of the electron beam 663, and $SS_{652}$ is the value corresponding to the amount of backscattered electrons 662 of the electron beam 661, the values of which are the true values to be detected. $N_{651}$ is the amount of backscattered electrons 664 of the electron beam 663 and $N_{652}$ is the amount of electrons (not shown) of the electron beam 661, the values of which serve as causes for degradation of the S/N ratio by superimposing on the true values.

$N_{651}$ is proportional to the amount $SS_{651}$ of the backscattered electron 665, as expressed by the following equation (3), and $N_{652}$ is proportional to the amount $SS_{652}$ of the backscattered electron 662, as expressed by the following equation (4). Namely, $N_{651}$ and $N_{652}$ will increase according to an increase in the backscattered electrons 665 and 662.

$$N_{651} = k \cdot SS_{651} \tag{3}$$

$$N_{652} = k \cdot SS_{652} \tag{4}$$

k in the foregoing equations (3) and (4) is a coefficient between $N_{651}$ and $SS_{651}$ and between $N_{652}$ and $SS_{652}$. The amount of this coefficient k is determined according to the positional relationship between the detectors 651 and 652. For instance, then two detectors 651 and 652 are closely arranged, the k becomes large, and when distanced, k becomes smaller. It should be noted that the coefficient between $N_{651}$ and $SS_{651}$ is not coincident with that between $N_{652}$ and $SS_{652}$, in the strict sense because of tolerances of the detectors. However, using a typical coefficient k derived on the basis of the average design data of the distance between the detectors and the size of the detecting surfaces will not create a problem.

Here, from the foregoing equations (1) and (2), the following equations (5) and (6) can be established.

$$PS_{651} = (1 - k^2) \cdot SS_{651} + k \cdot PS_{652} \tag{5}$$

$$PS_{652} = (1 - k^2) \cdot SS_{652} + k \cdot PS_{651} \tag{6}$$

Since k is less than 1,

$$PS_{651} \sim SS_{651} + k \cdot PS_{652}$$

$$\therefore SS_{651} \sim PS_{651} - k \cdot PS_{652} \tag{7}$$

$$PS_{652} \sim SS_{652} + k \cdot PS_{651}$$

$$\therefore SS_{652} \sim PS_{652} - k \cdot PS_{651} \tag{8}$$

Accordingly, in order to obtain the true signal $SS_{651}$ by removing the noise component $N_{652}$ from the detection signal $PS_{651}$ of the detector 651, the value is derived by multiplying the detection signal value $PS_{652}$ of the detector 652 by the coefficient k from the detection signal $PS_{651}$ of the detector 651. Similarly, in order to obtain the true signal $SS_{652}$ by removing the noise component $N_{651}$ from the detection signal $PS_{652}$ of the detector 652, the value is derived by multiplying the detection signal value $PS_{651}$ of the detector 651 by the coefficient k from the detection signal $PS_{652}$ of the detector 652.

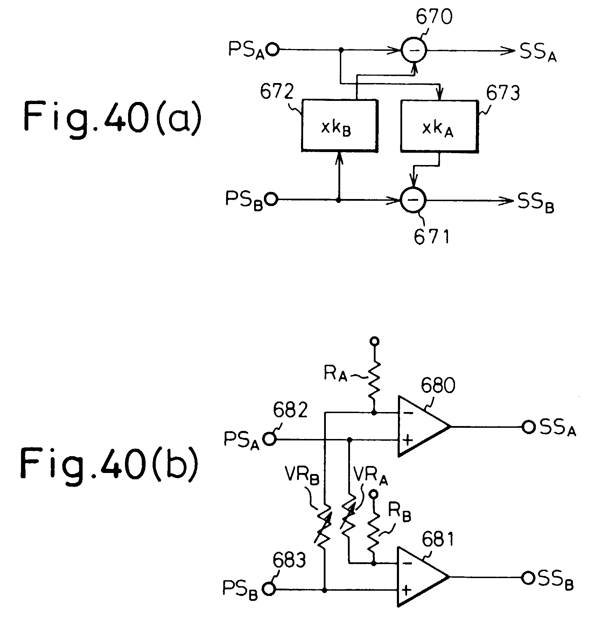

Fig. 40 is a block diagram showing a circuit for performing the foregoing subtraction process. In this example, as shown in Fig. 40(a), the shown embodiment of the circuit comprises two subtractors 670 and 671, and two multipliers 672 and 673. The multiplier 673 multiplies the detection signal $PS_A$ by a coefficient $k_A$. The subtractor 671 subtracts the product obtained by the multiplier 673 from the detection signal $PS_B$ to derive the true detection signal $SS_B$. Similarly, the multiplier 672 multiplies the detection signal $PS_B$ by a coefficient $k_B$. The subtractor 670 subtracts the product obtained by the multiplier 672 from the detection signal $PS_A$ to derive the true detection signal $SS_A$. In the preferred construction as shown in Fig. 40b, the subtractors are formed by operational amplifiers 680 and 681. The inverting inputs (-) of the operational amplifiers 680 and 681 are input via resistors $R_A$ and $R_B$ between respective inverting inputs (-) and the detection signal input terminals 682, 683; variable resistors $VR_A$ and $VR_B$ may be connected. By disposing the variable resistors $VR_A$ and $VR_B$, the coefficients ($k_A$, $k_B$) can be set freely.

In the foregoing example, discussion has been provided for the case that two detection signals are processed. However, in the practical implementation of pattern inspection apparatus according to the present invention, a greater number of detection signals have to be processed.

For example, Fig. 38 shows the example in which 9 detectors 651 to 659 are provided. In this example, several groups are formed with the detectors having a positional relationship to have equal coefficients with respect to the specific detector (for example, detector 655 of Fig. 38) for which the true detection signal is to be obtained. In the shown example, the detectors 652, 654. 656 and 658 form one group that will be hereafter referred to as group α, and the detectors 651, 653, 657 and 659 form another group hereafter referred to as group β. The detection signals of the detectors in each group are summed. The sum thus calculated is multiplied with the coefficient common for the detectors in the group. Namely, in the shown case, the sum of the detection signals in the group $\alpha$ is multiplied by the coefficient $k\alpha$. The product thus derived is subtracted from the detector signal $PS_{655}$ of the detector 655 to derive the true detector signal value. This process is expressed by the following equation (9):

$$SS_{655} = PS_{655} - k\alpha \cdot \Sigma PS\alpha - k\beta \cdot \Sigma PS\beta \qquad (9)$$

where

$$\Sigma PS\alpha = PS_{652} + PS_{654} + PS_{656} + PS_{658}$$

$$\Sigma PS\beta = PS_{651} + PS_{653} + PS_{657} + PS_{659}$$

Namely, in the foregoing equation (9), the common equations $k\alpha$ and $k\beta$ are used for the detector signals of the detectors positioned respectively at equal distance from the specific detector, for which the true detection signal $SS_{655}$ is to be derived.

If different coefficients are used, the following equation (10) is established:

$$SS_{655} = PS_{655} - k_{651\text{-}655} \cdot PS_{651} - k_{652\text{-}655} \cdot PS_{652}$$

$$- k_{653\text{-}655} \cdot PS_{653} - k_{654\text{-}655} \cdot PS_{654}$$

$$- k_{659\text{-}655} \cdot PS_{659} \qquad (10)$$

Note, the suffix, such as 651-655 represents the coefficient between the detectors 651 and 655.

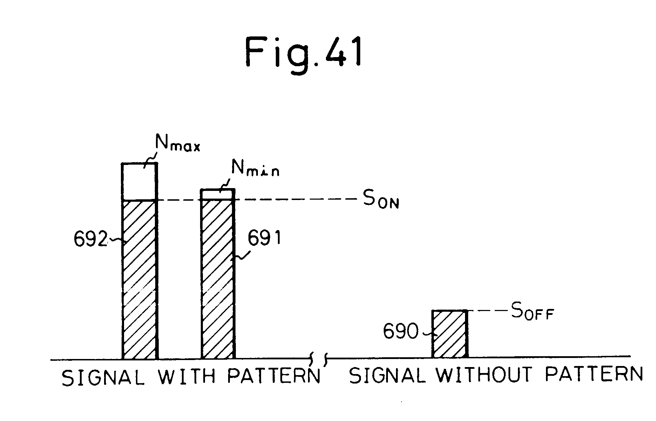

Further discussion will be provided about the enhancement of the S/N ratio with reference to Fig. 41. The detection signal in the case of no pattern, at which the backscattered electron from the irradiating region is minimum, is illustrated by a single bar graph 690. Conversely, the detection signal in the case that the pattern is present and thus the amount of the backscattered electron is large, is illustrated by a double line graph 691. In addition, the hatched areas of the bar graph represent the true detection signal values and respectively expressed by $S_{OFF}$ (pattern absent) and $S_{ON}$ (pattern present).

Now, consideration is provided for the case that the pattern is present. In this case, assuming that the backscattered electron of the adjacent electron beam is zero, the signal $S_{ON}$ corresponding to the hatched portion of the bar graph 691 (or 692), namely the true detection signal, can be obtained when the backscattered electron of the adjacent electron beam is included in the detection signal as the noise component. In this case, when all of the adjacent irradiating regions have patterns, the maximum noise component ($N_{max}$) should be superimposed on the true detection signal. On the other hand, when all of the adjacent irradiating regions have no patterns, the minimum noise component ($N_{min}$) is superimposed on the true detection signal. The following equation expresses the S/N ratio of the case of Fig. 41.

$$S/N = (S_{ON} - S_{OFF})/(S_{ON} + "N" - S_{ON}) \qquad (11)$$

In the foregoing equation "N" is to be replaced for $N_{max}$ to $N_{min}$. The greater N value will degrade the S/N ratio. Therefore, by setting an optimum coefficient k (it is desirable to vary depending upon the presence and absence of the pattern) with respect to the adjacent beams to subtract the product ($k \cdot S_{ON}$) of the coefficient k and the detection signal value of the adjacent beam from the detection signal value to compensate for the noise component, the S/N ratio can be enhanced.

It should be noted that the electron beam scanning device is applicable not only to the electron beam drawing system and electron beam inspection system but also to a plane display system or a wide variety of electron beam utilizing products.

With the foregoing embodiment, the interference of backscattered electrons of adjacent beams can be positively prevented or successfully compensated for to obtain an enhanced S/N ratio.

**Claims**

1.  An electron beam apparatus comprising:

    a plurality of electron beam emitters (2, 301, 501, 531) arranged on a common substrate (100, 502, 520, 530) or on a plurality of individual substrates arranged on the same plane, each arranged to emit an electron beam (B, 361, 522, 623, 661) onto a respective region of a sample (S, 310, 513, 526, 534, 612, 625) and provided with at least a convergence electrode or a converging coil (102, 421, 524, 630) providing a convergence ratio for said electron beam corresponding to an electrode voltage or an energization current;
    a plurality of detectors (4, 41, 508, 529, 613, 632, 651) for detecting electrons emitted from said sample; and signal processing means (5, 52, 305, 660) for processing information output from said detectors;

    characterised in that:

    said apparatus is a pattern inspection apparatus for inspecting the condition of a pattern (T) formed on said sample;
    said plurality of detectors correspond one to one with said electron beam emitters and are arranged to detect electrons emitted from said respective regions of said sample; and
    said signal processing means is arranged to perform image processing simultaneously or in parallel of the information output from said plurality of detectors .

2.  An apparatus according to claim 1, wherein each said electron beam emitter is provided with an electron emitter (101, 411, 503, 531) having a sharp headed tip end and a gate surrounding said tip end.

3.  An apparatus according to claim 2, wherein each said electron beam emitter is provided with an extracting electrode (523) for extracting from said electron emitter an electron beam having a beam current corresponding to an electrode voltage.

4.  An apparatus according to claim 1, 2 or 3, wherein each said electron beam emitter (2, 301, 501, 531) is provided with a deflecting electrode or a deflecting coil (103, 331, 507, 525, 631) providing a deflection angle for said electron beam (B, 361, 522, 623, 661) corresponding to an electrode voltage or an energization current.

5.  An apparatus as claimed in claim 2 or 3, wherein said detectors (632) are arranged between said electrodes (630, 631) and said electron emitters.

6.  An apparatus according to any of claims 2 to 5, wherein said electron emitter (101, 411, 503) and each electrode or coil (102, 103, ....) of each electron beam emitter, as well as its corresponding detector (4, 304, 508, 529, 613, 632, 651), are formed as laminations of the same substrate (100, 502, 520, 530).

7.  An apparatus according to any preceding claim, further comprising a movable support (3, 309, 535) for supporting said inspection sample (S, 310, 513, 526, 534, 612, 625).

8.  An apparatus according to any preceding claim, further comprising a drive mechanism (35) for moving said plurality of electron beam emitters (2, 301, 501, 531) in a plane parallel to a surface of said inspection sample (S, 310, 513, 526, 534, 612, 625).

9.  An apparatus as claimed in any preceding claim, wherein said detectors (4, 41, 508, 529, 613, 632, 651) are arranged in parallel relationship relative to a plane of said inspection sample (S, 310, 513, 526, 534, 612, 625) and in alignment in a single dimensional direction.

10. An apparatus as claimed in any preceding claim, wherein said detectors (4, 41, 508, 529, 613, 632, 651) are arranged in parallel relationship relative to a plane of said inspection sample (S, 310, 513, 526, 534, 612, 625) and in alignment in two dimensional directions.

11. An apparatus as claimed in any preceding claim, wherein two or more of said electron beams (B, 361, 522, 623, 661) are irradiated simultaneously onto said sample (S, 310, 513, 526, 534, 612, 625).

12. An apparatus as claimed in any preceding claim, wherein two or more of said electron beams (B, 361, 522, 623, 661) are formed into pulses having different periods.

13. An apparatus as claimed in any preceding claim, wherein two or more of said electron beams are formed into pulses having mutually different pulse widths.

14. An apparatus as claimed in any preceding claim, wherein two or more of said electron beams are modulated by modulation signals having mutually distinct signal patterns.

15. An apparatus as claimed in claim 14, wherein said modulation signals are pulse signals having mutually different pulse widths and mutually identical repeating periods.

16. An apparatus as claimed in claim 14, wherein said modulation signals are pulse signals having mutually identical repeating periods and mutually different pulse peak timings.

17. An apparatus as claimed in claim 12, wherein said signal processing means (5, 52, 305, 660) corrects information relating to the condition of said inspection sample irradiated by said respective beams in synchronism with the pulse periods of said respective electron beams.

18. An apparatus as claimed in claim 13, wherein said signal processing means detects respective pulse widths of said respective electron beams and processes information relating to the condition of said inspection sample irradiated by said respective electron beams.

19. An apparatus as claimed in claim 15, wherein said signal processing means detects the pulse widths of the modulated electron beams and processes information relating to the condition of said inspection sample irradiated by said respective electron beams.

20. An apparatus as claimed in claim 13, wherein said signal processing means processes said electron beams formed into pulses having mutually different pulse widths in a time division multiplexing manner.

21. An apparatus as claimed in claim 14, 15, or 16, wherein said signal processing means includes an electron flow detector and a signal discriminator for discriminating information relating to the condition of said sample at respective irradiation regions from the output signal of said electron flow detector using said modulation signal as a reference.

22. An apparatus as claimed in any preceding claim, comprising an electron beam scanner (35, 303) for deflecting said plurality of electron beam emitters as a whole relative to said sample.

23. An apparatus as claimed in claim 22, wherein said electron beam scanner includes a mechanical scanner (35) for shifting either said plurality of electron beam emitters or said inspection sample.

24. An apparatus as claimed in claim 23, wherein said mechanical scanner includes a fine shifting stage that is shifted in at least one direction by actuation of a piezoelectric oscillator.

25. An apparatus as claimed in any preceding claim, further comprising a collimating unit (615, 622) for collimating electrons emitted from a specific region of said inspection sample to its respective detector, and preventing each detector from being interfered with by other electrons emitted from regions arranged adjacent to said specific region.

26. An apparatus as claimed in claim 25, wherein said collimating unit comprises a mask (615) having an opening with a predetermined internal diameter, said mask being arranged so as to align the center of said opening with the axis of a corresponding electron beam at a position between the inspection sample and a corresponding detector, said mask being located at a distance from the inspecting sample based on the distance between the surface of the inspection sample and a corresponding detector and the size of the detector.

27. An apparatus as claimed in claim 25 or 26, wherein said collimating unit comprises a plurality of thin tubes (622) respectively having predetermined lengths and being arranged so that the longitudinal axes of said thin tubes extend parallel to the beam axes of said electron beams.

**28.** An apparatus as claimed in any preceding claim, further comprising an adjustment unit for adjusting all of or part of respective electrode voltages or energization voltages to be applied to said electron beam emitters (2, 301, 501, 531).

**29.** An apparatus as claimed in claim 28, wherein said adjustment unit selectively connects or disconnects respective elements or connecting wiring of a resistor network.

**30.** An apparatus as claimed in claim 29, wherein said elements of said resistor network comprise resistors (R).

**31.** An apparatus as claimed in any preceding claim, further comprising a calculator unit (Fig. 28) for measuring a spot diameter or deflection angle of each electron beam on the basis of the signal from the respective said detector, and calculating a correction amount for correcting all of or part of respective electrode voltages or energization currents of the respective electron beam emitter (531).

**32.** An apparatus as claimed in any preceding claim, wherein said detectors (4, 41, 508, 529, 613, 632, 651) are arranged to catch backscattered or secondary electrons from the surface of said inspection sample (S, 310, 513, 526, 534, 612, 625) with respect to each of said electron beams (B, 361, 522, 623, 661), and the condition of the surface of said inspection sample is determined on the basis of the amount of backscattered or secondary electrons caught by said detectors.

**33.** An apparatus as claimed in any preceding claim, further comprising means (660) for correcting a detection value from any one of said plurality of detectors by subtracting a noise value formed by summing a plurality of detection values from adjacent detectors each multiplied by a predetermined coefficient, to thereby eliminate information based upon electrons emitted from adjacent regions of said inspection sample.

**Patentansprüche**

**1.** Elektronenstrahl-Vorrichtung, mit:

einer Vielzahl von Elektronenstrahl-Emittern (2, 301, 501, 531), die auf einem gemeinsamen Substrat (100, 502, 520, 530) oder auf einer Vielzahl auf derselben Ebene liegender einzelner Substrate angeordnet sind, die jeweils eingerichtet sind, einen Elektronenstrahl (B, 361, 522, 623, 661) auf eine entsprechende Zone einer Probe (S, 310, 513, 526, 534, 612, 625) zu emittieren, und die mit zumindest einer Konvergenzelektrode oder einer Konvergenzspule (102, 421, 524, 630) versehen sind, welche ein Konvergenzverhältnis für den Elektronenstrahl vorsieht, das einer Elektrodenspannung oder einem Erregungsstrom entspricht; einer Vielzahl von Detektoren (4, 41, 508, 529, 613, 632, 651) zum Detektieren von der Probe emittierter Elektronen; und einer Signalverarbeitungseinrichtung (5, 52, 305, 660) zum Verarbeiten von aus den Detektoren ausgegebenen Informationen;

dadurch gekennzeichnet, daß:

die Vorrichtung eine Musterinspektionsvorrichtung zum Inspizieren des Zustands eines auf der Probe gebildeten Musters (T) ist; die Vielzahl von Detektoren den Elektronenstrahl-Emittern Eins-zu-Eins entspricht und eingerichtet ist, von den entsprechenden Zonen der Probe emittierte Elektronen zu detektieren; und die Signalverarbeitungseinrichtung eingerichtet ist, eine Bildverarbeitung gleichzeitig mit oder parallel zu den aus der Vielzahl von Detektoren ausgegebenen Informationen durchzuführen.

**2.** Vorrichtung nach Anspruch 1, bei welcher jeder Elektronenstrahl-Emitter mit einem Elektronen-Emitter (101, 411, 503, 531) versehen ist, der ein Ende mit einer Spitze mit einem scharfen Kopf und ein dieses Ende mit der Spitze umgebendes Gatter aufweist.

**3.** Vorrichtung nach Anspruch 2, bei welcher jeder Elektronenstrahl-Emitter mit einer Extraktionselektrode (523) zum Extrahieren eines Elektronenstrahls aus dem Elektronen-Emitter mit einem einer Elektrodenspannung entsprechenden Strahlstrom versehen ist.

4. Vorrichtung nach Anspruch 1, 2 oder 3, bei welcher jeder Elektronenstrahl-Emitter (2, 301, 501, 531) mit einer Ablenkelektrode oder einer Ablenkspule (103, 331, 507, 525, 631) versehen ist, die einen Ablenkwinkel für den Elektronenstrahl (B, 361, 522, 623, 661) vorsieht, der einer Elektrodenspannung oder einem Erregungsstrom entspricht.

5. Vorrichtung nach Anspruch 2 oder 3, bei welcher die Detektoren (632) zwischen den Elektroden (630, 631) und den Elektronen-Emittern angeordnet sind.

6. Vorrichtung nach einem der Ansprüche 2 bis 5, bei welcher der Elektronen-Emitter (101, 411, 503) und jede Elektrode oder Spule (102, 103, ...) jedes Elektronenstrahl-Emitters sowie sein entsprechender Detektor (4, 304, 508, 529, 613, 632, 651) als Laminierungen desselben Substrats (100, 502, 520, 530) gebildet sind.

7. Vorrichtung nach einem der vorhergehenden Ansprüche, ferner mit einem bewegbaren Träger (3, 309, 535) zum Tragen der Inspektionsprobe (S, 310, 513, 526, 534, 612, 625).

8. Vorrichtung nach einem der vorhergehenden Ansprüche, ferner mit einem Antriebsmechanismus (35) zum Bewegen der Vielzahl von Elektronenstrahl-Emittern (2, 301, 501, 531) in einer Ebene parallel zu einer Oberfläche der Inspektionsprobe (S, 310, 513, 526, 534, 612, 625).

9. Vorrichtung nach einem der vorhergehenden Ansprüche, bei welcher die Detektoren (4, 41, 508, 529, 613, 632, 651) in paralleler Beziehung relativ zu einer Ebene der Inspektionsprobe (S, 310, 513, 526, 534, 612, 625) und in Ausrichtung in einer eindimensionalen Richtung angeordnet sind.

10. Vorrichtung nach einem der vorhergehenden Ansprüche, bei welcher die Detektoren (4, 41, 508, 529, 613, 632, 651) in paralleler Beziehung relativ zu einer Ebene der Inspektionsprobe (S, 310, 513, 526, 534, 612, 625) und in Ausrichtung in zweidimensionalen Richtungen angeordnet sind.

11. Vorrichtung nach einem der vorhergehenden Ansprüche, bei welcher zwei oder mehrere der Elektronenstrahlen (B, 361, 522, 623, 661) gleichzeitig auf die Probe (S, 310, 513, 526, 534, 612, 625) eingestrahlt werden.

12. Vorrichtung nach einem der vorhergehenden Ansprüche, bei welcher zwei oder mehrere der Elektronenstrahlen (B, 361, 522, 623, 661) zu Impulsen mit verschiedenen Perioden geformt werden.

13. Vorrichtung nach einem der vorhergehenden Ansprüche, bei welcher zwei oder mehrere der Elektronenstrahlen zu Impulsen mit voneinander verschiedenen Impulsbreiten geformt werden.

14. Vorrichtung nach einem der vorhergehenden Ansprüche, bei welcher zwei oder mehrere der Elektronenstrahlen durch Modulationssignale mit voneinander unterschiedlichen Signalmustern moduliert werden.

15. Vorrichtung nach Anspruch 14, bei welcher die Modulationssignale Impulssignale mit voneinander verschiedenen Impulsbreiten und miteinander identischen Wiederholungsperioden sind.

16. Vorrichtung nach Anspruch 14, bei welcher die Modulationssignale Impulssignale mit miteinander identischen Wiederholungsperioden und voneinander verschiedenen Impulsspitzenzeiten sind.

17. Vorrichtung nach Anspruch 12, bei welcher die Signalverarbeitungseinrichtung (5, 52, 305, 660) Informationen über den Zustand der Inspektionsprobe, auf welche die entsprechenden Strahlen eingestrahlt werden, synchron mit den Impulsperioden der entsprechenden Elektronenstrahlen korrigiert.

18. Vorrichtung nach Anspruch 13, bei welcher die Signalverarbeitungseinrichtung entsprechende Impulsbreiten der entsprechenden Elektronenstrahlen detektiert und Informationen über den Zustand der Inspektionsprobe, auf welche die entsprechenden Elektronenstrahlen eingestrahlt werden, verarbeitet.

19. Vorrichtung nach Anspruch 15, bei welcher die Signalverarbeitungseinrichtung die Impulsbreiten der modulierten Elektronenstrahlen detektiert und Informationen über den Zustand der Inspektionsprobe, auf welche die entsprechenden Elektronenstrahlen eingestrahlt werden, verarbeitet.

20. Vorrichtung nach Anspruch 13, bei welcher die Signalverarbeitungseinrichtung die zu Impulsen mit voneinander verschiedenen Impulsbreiten geformten Elektronenstrahlen auf Zeitmultiplex-Weise verarbeitet.

21. Vorrichtung nach Anspruch 14, 15 oder 16, bei welcher die Signalverarbeitungseinrichtung einen Elektronenfluß-Detektor und einen Signaldiskriminator zum Diskriminieren von Informationen über den Zustand der Probe an entsprechenden Einstrahlzonen aus dem Ausgangssignal des Elektronenfluß-Detektors unter Verwendung des Modulationssignals als Bezug enthält.

22. Vorrichtung nach einem der vorhergehenden Ansprüche, mit einem Elektronenstrahl-Scanner (35, 303) zum Ablenken der Vielzahl von Elektronenstrahl-Emittern als Gesamtheit relativ zur Probe.

23. Vorrichtung nach Anspruch 22, bei welcher der Elektronenstrahl-Scanner einen mechanischen Scanner (35) zum Verschieben entweder der Vielzahl von Elektronenstrahl-Emittern oder der Inspektionsprobe enthält.

24. Vorrichtung nach Anspruch 23, bei welcher der mechanische Scanner eine Feinverschiebungsbühne enthält, die in zumindest einer Richtung durch die Betätigung eines piezoelektrischen Oszillators verschoben wird.

25. Vorrichtung nach einem der vorhergehenden Ansprüche, ferner mit einer Kollimatoreinheit (615, 622) zum Kollimieren von Elektronen, die von einer spezifischen Zone der Inspektionsprobe zu ihrem entsprechenden Detektor emittiert werden, und Verhindern, daß andere Elektronen, die von der spezifischen Zone benachbarten Zonen emittiert werden, mit dem Detektor interferieren.

26. Vorrichtung nach Anspruch 25, bei welcher die Kollimatoreinheit eine Maske (615) mit einer Öffnung mit einem vorherbestimmten Innendurchmesser umfaßt, welche Maske so angeordnet ist, daß das Zentrum der Öffnung mit der Achse eines entsprechenden Elektronenstrahls an einer Position zwischen der Inspektionsprobe und einem entsprechenden Detektor ausgerichtet ist, welche Maske in einer Distanz von der Inspektionsprobe vorliegt, die auf der Distanz zwischen der Oberfläche der Inspektionsprobe und einem entsprechenden Detektor und der Größe des Detektors basiert.

27. Vorrichtung nach Anspruch 25 oder 26, bei welcher die Kollimatoreinheit eine Vielzahl dünner Röhrchen (622) umfaßt, die jeweils vorherbestimmte Längen haben und so angeordnet sind, daß die Längsachsen der dünnen Röhrchen parallel zu den Strahlachsen der Elektronenstrahlen verlaufen.

28. Vorrichtung nach einem der vorhergehenden Ansprüche, ferner mit einer Einstelleinheit zum Einstellen aller oder eines Teils entsprechender Elektrodenspannungen oder Erregungsspannungen, die an die Elektronenstrahl-Emitter (2, 301, 501, 531) anzulegen sind.

29. Vorrichtung nach Anspruch 28, bei welcher die Einstelleinheit selektiv entsprechende Elemente oder Verbindungsdrähte eines Widerstandsnetzes verbindet oder trennt.

30. Vorrichtung nach Anspruch 29, bei welcher die Elemente des Widerstandsnetzes Widerstände (R) umfassen.

31. Vorrichtung nach einem der vorhergehenden Ansprüche, ferner mit einer Rechnereinheit (Fig.28) zum Messen eines Fleckdurchmessers oder Ablenkwinkels jedes Elektronenstrahls auf der Basis des Signals aus dem entsprechenden Detektor, und Berechnen eines Korrekturbetrags zum Korrigieren aller oder eines Teils entsprechender Elektrodenspannungen oder Erregungsströme des entsprechenden Elektronenstrahl-Emitters (531).

32. Vorrichtung nach einem der vorhergehenden Ansprüche, bei welcher die Detektoren (4, 41, 508, 529, 613, 632, 651) eingerichtet sind, rückgestreute oder sekundäre Elektronen von der Oberfläche der Inspektionsprobe (S, 310, 513, 526, 534, 612, 625) in bezug auf jeden der Elektronenstrahlen (B, 361, 522, 623, 661) einzufangen, und der Zustand der Oberfläche der Inspektionsprobe auf der Basis der Menge der von den Detektoren eingefangenen rückgestreuten oder sekundären Elektronen bestimmt wird.

33. Vorrichtung nach einem der vorhergehenden Ansprüche, ferner mit einer Einrichtung (660) zum Korrigieren eines Detektionswerts von irgendeinem der Vielzahl von Detektoren durch das Subtrahieren eines Rauschwerts, der durch das Summieren einer Vielzahl von 0 benachbarter Detektoren, jeweils mit einem vorherbestimmten Koeffizienten multipliziert, gebildet wird, um dadurch Informationen auf der Basis von Elektronen zu eliminieren, die von benachbarten Zonen der Inspektionsprobe emittiert werden.

**Revendications**

1. Appareil à faisceau d'électrons comprenant :

   une pluralité d'émetteurs de faisceau d'électrons (2, 301, 501, 531) agencés sur un substrat commun (100, 502, 520, 530) ou sur une pluralité de substrats individuels agencés sur le même plan, chacun étant agencé pour émettre un faisceau d'électrons (B, 361, 522, 623, 661) sur une région respective d'un échantillon (S, 310, 513, 526, 534, 612, 625) et étant muni d'au moins une électrode de convergence ou une bobine de convergence (102, 421, 524, 630) assurant un rapport de convergence pour ledit faisceau d'électrons correspondant à une tension d'électrode ou à un courant d'alimentation ;
   une pluralité de détecteurs (4, 41, 508, 529, 613, 632, 651) pour détecter des électrons émis depuis ledit échantillon ; et
   un moyen de traitement de signal (5, 52, 305, 660) pour traiter une information émise en sortie depuis lesdits détecteurs,

   caractérisé en ce que :

   ledit appareil est un appareil d'inspection de motif permettant d'inspecter la condition d'un motif (T) formé sur ledit échantillon ;
   les détecteurs de ladite pluralité de détecteurs correspondent selon une relation biunivoque auxdits émetteurs de faisceau d'électrons et sont agencés pour détecter des électrons émis depuis lesdites régions respectives dudit échantillon ; et
   ledit moyen de traitement de signal est agencé pour réaliser un traitement d'image simultanément ou en parallèle de l'information émise en sortie depuis ladite pluralité de détecteurs.

2. Appareil selon la revendication 1, dans lequel chaque dit émetteur de faisceau d'électrons est muni d'un émetteur d'électrons (101, 411, 503, 531) comportant une extrémité à pointe acérée et une grille entourant ladite extrémité.

3. Appareil selon la revendication 2, dans lequel chaque dit émetteur de faisceau d'électrons est muni d'une électrode d'extraction (523) pour extraire à partir dudit émetteur d'électrons un faisceau d'électrons présentant un courant de faisceau correspondant à une tension d'électrode.

4. Appareil selon la revendication 1, 2 ou 3, dans lequel chaque dit émetteur de faisceau d'électrons (2, 301, 501, 531) est muni d'une électrode de déviation ou d'une bobine de déviation (103, 331, 507, 525, 631) assurant un angle de déviation pour ledit faisceau d'électrons (B, 361, 522, 623, 661) correspondant à une tension d'électrode ou à un courant d'alimentation.

5. Appareil selon la revendication 2 ou 3, dans lequel lesdits détecteurs (632) sont agencés entre lesdites électrodes (630, 631) et lesdits émetteurs d'électrons.

6. Appareil selon l'une quelconque des revendications 2 à 5, dans lequel ledit émetteur d'électrons (101, 411, 503) et chaque électrode ou bobine (102, 103, ...) de chaque émetteur de faisceau d'électrons ainsi que son détecteur correspondant (4, 304, 508, 529, 613, 632, 651) sont formés en tant que stratifications du même substrat (100, 502, 520, 530).

7. Appareil selon l'une quelconque des revendications précédentes, comprenant en outre un support mobile (3, 309, 535) pour supporter ledit échantillon d'inspection (S, 310, 513, 526, 534, 612, 625).

8. Appareil selon l'une quelconque des revendications précédentes, comprenant en outre un mécanisme d'entraînement (35) pour déplacer ladite pluralité d'émetteurs de faisceau d'électrons (2, 301, 501, 531) dans un plan parallèle à une surface dudit échantillon d'inspection (S, 310, 513, 526, 534, 612, 625).

9. Appareil selon l'une quelconque des revendications précédentes, dans lequel lesdits détecteurs (4, 41, 508, 529, 613, 632, 651) sont agencés selon une relation de parallélisme par rapport à un plan dudit échantillon d'inspection (S, 310, 513, 526, 534, 612, 625) et en alignement suivant une seule direction dimensionnelle.

10. Appareil selon l'une quelconque des revendications précédentes, dans lequel lesdits détecteurs (4, 41, 508, 529, 613, 632, 651) sont agencés selon une relation de parallélisme par rapport à un plan dudit échantillon d'inspection (S, 310, 513, 526, 534, 612, 625) et en alignement suivant deux directions dimensionnelles.

11. Appareil selon l'une quelconque des revendications précédentes, dans lequel deux ou plus desdits faisceaux d'électrons (B, 361, 522, 623, 661) sont irradiés simultanément sur ledit échantillon (S, 310, 513, 526, 534, 612, 625).

12. Appareil selon l'une quelconque des revendications précédentes, dans lequel deux ou plus desdits faisceaux d'électrons (B, 361, 522, 623, 661) sont formés selon des impulsions présentant des périodes différentes.

13. Appareil selon l'une quelconque des revendications précédentes, dans lequel deux ou plus desdits faisceaux d'électrons sont formés selon des impulsions présentant des largeurs d'impulsion mutuellement différentes.

14. Appareil selon l'une quelconque des revendications précédentes, dans lequel deux ou plus desdits faisceaux d'électrons sont modulés par des signaux de modulation présentant des motifs de signal mutuellement distincts.

15. Appareil selon la revendication 14, dans lequel lesdits signaux de modulation sont des signaux impulsionnels présentant des largeurs d'impulsion mutuellement différentes et des périodes de répétition mutuellement identiques.

16. Appareil selon la revendication 14, dans lequel lesdits signaux de modulation sont des signaux impulsionnels présentant des périodes de répétition mutuellement identiques et des cadencements de crête d'impulsion mutuellement différents.

17. Appareil selon la revendication 12, dans lequel ledit moyen de traitement de signal (5, 52, 305, 660) corrige une information se rapportant à la condition dudit échantillon d'inspection irradié par lesdits faisceaux respectifs en synchronisation avec les périodes d'impulsion desdits faisceaux d'électrons respectifs.

18. Appareil selon la revendication 13, dans lequel ledit moyen de traitement de signal détecte des largeurs d'impulsion respectives desdits faisceaux d'électrons respectifs et traite une information se rapportant à la condition dudit échantillon d'inspection irradié par lesdits faisceaux d'électrons respectifs.

19. Appareil selon la revendication 15, dans lequel ledit moyen de traitement de signal détecte les largeurs d'impulsion des faisceaux d'électrons modulés et traite une information se rapportant à la condition dudit échantillon d'inspection irradié par lesdits faisceaux d'électrons respectifs.

20. Appareil selon la revendication 13, dans lequel ledit moyen de traitement de signal traite lesdits faisceaux d'électrons formés selon des impulsions présentant des largeurs d'impulsion mutuellement différentes par multiplexage par répartition temporelle.

21. Appareil selon la revendication 14, 15 ou 16, dans lequel ledit moyen de traitement de signal inclut un détecteur de flux d'électrons et un discriminateur de signal pour discriminer une information se rapportant à la condition dudit échantillon au niveau de régions d'irradiation respectives à partir du signal de sortie dudit détecteur de flux d'électrons en utilisant ledit signal de modulation en tant que référence.

22. Appareil selon l'une quelconque des revendications précédentes, comprenant un dispositif de balayage de faisceau d'électrons (35, 303) pour dévier ladite pluralité d'émetteurs de faisceau d'électrons de façon globale par rapport audit échantillon.

23. Appareil selon la revendication 22, dans lequel ledit dispositif de balayage de faisceau d'électrons inclut un dispositif de balayage mécanique (35) pour décaler soit ladite pluralité d'émetteurs de faisceau d'électrons, soit ledit échantillon d'inspection.

24. Appareil selon la revendication 23, dans lequel ledit dispositif de balayage mécanique inclut un étage de décalage fin qui est décalé suivant au moins une direction par l'activation d'un oscillateur piézoélectrique.

25. Appareil selon l'une quelconque des revendications précédentes, comprenant en outre une unité de collimation (615, 622) pour collimater des électrons émis depuis une région spécifique dudit échantillon d'inspection sur son détecteur respectif et pour empêcher chaque détecteur d'être soumis à une interférence du fait d'autres électrons émis depuis des régions agencées de manière à être adjacentes à ladite région spécifique.

26. Appareil selon la revendication 25, dans lequel ladite unité de collimation comprend un masque (615) comportant une ouverture présentant un diamètre interne prédéterminé, ledit masque étant agencé de manière à aligner le centre de ladite ouverture avec l'axe d'un faisceau d'électrons correspondant en une position entre l'échantillon d'inspection et un détecteur correspondant, ledit masque étant situé à une certaine distance de l'échantillon d'inspection sur la base de la distance entre la surface de l'échantillon d'inspection et un détecteur correspondant et sur la base de la taille du détecteur.

27. Appareil selon la revendication 25 ou 26, dans lequel ladite unité de collimation comprend une pluralité de tubes minces (622) présentant respectivement des longueurs prédéterminées et agencés de telle sorte que les axes longitudinaux desdits tubes minces s'étendent parallèlement aux axes de faisceau desdits faisceaux d'électrons.

28. Appareil selon l'une quelconque des revendications précédentes, comprenant en outre une unité de réglage pour régler toutes les tensions d'électrode respectives ou les tensions d'alimentation respectives ou une partie de celles-ci qui sont à appliquer sur lesdits émetteurs de faisceau d'électrons (2, 301, 501, 531).

29. Appareil selon la revendication 28, dans lequel ladite unité de réglage connecte ou déconnecte sélectivement des éléments respectifs ou un câblage de connexion d'un réseau de résistances.

30. Appareil selon la revendication 29, dans lequel lesdits éléments dudit réseau de résistances comprennent des résistances (R).

31. Appareil selon l'une quelconque des revendications précédentes, comprenant en outre une unité de calculateur (figure 28) pour mesurer un diamètre de spot ou un angle de déviation de chaque faisceau d'électrons sur la base du signal provenant dudit détecteur respectif et pour calculer une valeur de correction pour corriger toutes les tensions d'électrode respectives ou tous les courants d'alimentation respectifs ou une partie de celles-ci ou de ceux-ci de l'émetteur de faisceau d'électrons respectif (531).

32. Appareil selon l'une quelconque des revendications précédentes, dans lequel lesdits détecteurs (4, 41, 508, 529, 613, 632, 651) sont agencés pour capturer des électrons rétrodiffusés ou secondaires provenant de la surface dudit échantillon d'inspection (S, 310, 513, 526, 534, 612, 625) en relation avec chacun desdits faisceaux d'électrons (B, 361, 522, 623, 661) et la condition de la surface dudit échantillon d'inspection est déterminée sur la base de la quantité d'électrons rétrodiffusés ou secondaires capturés par lesdits détecteurs.

33. Appareil selon l'une quelconque des revendications précédentes, comprenant en outre un moyen (660) pour corriger une valeur de détection provenant de l'un quelconque de ladite pluralité de détecteurs en soustrayant une valeur de bruit formée en sommant une pluralité de valeurs de détection provenant de détecteurs adjacents dont chacune est multipliée par un coefficient prédéterminé pour ainsi éliminer une information sur la base d'électrons émis depuis des régions adjacentes dudit échantillon d'inspection.

# Fig.1(a)

# Fig.1(b)

# Fig. 2

# Fig. 3(a)

# Fig. 3(b)

# Fig. 3(c)

# Fig. 4

# Fig. 5

TO PARALLEL SIGNAL
PROCESSING CIRCUIT

# Fig. 6

TO PARALLEL SIGNAL
PROCESSING CIRCUIT

# Fig. 7

P

S

31

33

32

34

3

# Fig.8

101

100

}~102
}~103 } 25

B

S

4

TO PARALLEL SIGNAL
PROCESSING CIRCUIT

# Fig. 9(a)  Fig. 9(b)

# Fig.10(a)  Fig.10(b)

# Fig.11

# Fig.12

REFLECTED
ELECTRON

# Fig.13

# Fig.14

# Fig.15

# Fig.16

# Fig. 17

# Fig.18

# Fig.19

ELECTRON BEAM
SUPPLY MEANS — 301

ELECTRON BEAM
SCANNING MEANS — 303

MODULATION
SIGNAL 1

ELECTRON
BEAM

ELECTRON
BEAM

MODULATION
SIGNAL 2

302

ELECTRON BEAM
MODULATING MEANS

ELECTRON BEAM
MODULATING MEANS — 302

304. ELECTRON FLOW
DETECTING MEANS

305

SIGNAL
PROCESSING
MEANS

ELECTRON FLOW

ELECTRON FLOW

310

INSPECTING SAMPLE

EP 0 518 633 B1

Fig. 20

Fig. 21(a)

Fig. 21(b)

Fig. 21(c)

Fig. 21(d)

Fig. 21(e)

# Fig. 22

# Fig. 23

# Fig.24

# Fig. 25

# Fig. 26

SMALL SPOT

LARGE SPOT

INSPECTING
SAMPLE

DEFECT

DEFECT

JUDGEMENT
LEVEL

a

b

CAN BE
RECOGNIZED

CANNOT BE
RECOGNIZED

# Fig. 27

IRRADIATING
REGION

IRRADIA
-TING
REGION

IRRADIATING
REGION

OVERLAPPING
REGION

NOT IRRADIATED
REGION

# Fig. 28

520

521
523
524
525
522
529

527

526

528

529

530

VOLTAGE SOURCE
OR
CURRENT SOURCE

ARITHMETIC
MEANS

Fig. 29

# Fig. 30(a)

# Fig. 30(b)

EXTRACTION

RESULT OF CUTTING

EP 0 518 633 B1

# Fig. 31

# Fig. 32(a)

# Fig. 32(b)

# Fig.33(a)

A     B     C

UNIT PATTERN

ELECTRON BEAM

# Fig.33(b)

LARGE

CURRENT

La

A          B          C

# Fig.33(c)

LARGE

CURRENT

Lb

A          B          C

# Fig.34(a)

A    B    C

DISCHARGED
ELECTRON

LIGHT
METAL

HEAVY
METAL

# Fig.34(b)

LARGE

CURRENT

Lc

A      B      C

# Fig. 35(a)

UNIT PATTERN

$F_1$

$F_3$

$F_2$

# Fig. 35(b)

$F_1$

$B_1$  $B_2$  $B_3$  $B_4$  $B_5$

$P_1$  $P_2$  $P_3$  $P_4$  $P_5$

# Fig. 35(c)

$L_1$  $L_2$  $L_3$  $L_4$  $L_5$

# Fig.36

623    624
620    621
622
BUNDLE OF FINE
HOLLOW TUBES

626
627
625

REFLECTED
ANGLE

# Fig.37

632
630

635
634
636

631

# Fig. 38

# Fig.39

## Fig.40(a)

## Fig.40(b)

# Fig.41

SIGNAL WITH PATTERN    SIGNAL WITHOUT PATTERN

# Fig.42(a)

# Fig.42(b)

# Fig.42(c)

Fig.43(a)-1

Fig.43(a)-2

Fig.43(a)-3

Fig.43(b)

Fig.43(c)

Fig.43(d)

Fig.44

V₀

R₁  R₂  R₃  R₄

TR₁  TR₂  TR₃  TR₄

TO LENS
ELECTRODE

# Fig. 45

# Fig. 46